# EUROPEAN PATENT APPLICATION

(11) **EP 1 533 835 A1**
(43) Date of publication of application: **25.05.2005**
(21) Application number: 03733161.8
(22) Date of filing: 29.05.2003
(51) Int. Cl.: H01L 21/205

(54) **VAPORIZER, VARIOUS APPARATUSES INCLUDING THE SAME AND METHOD OF VAPORIZATION**

(30) Priority: 29.05.2002 JP 2002156521
(71) Applicant: KABUSHIKI KAISHA WATANABE SHOKO, Chuo-ku, Tokyo 103-0022 (JP); Toda, Masayuki, Yonezawa-shi, Yamagata 992-0026 (JP)
(72) Inventor: TODA, Masayuki, Yonezawa-shi, Yamagata 992-0026 (JP); UMEDA, Masaru, KABUSHIKI KAISHA WATANABE SHOKO, Tokyo 103-0022 (JP)
(74) Representative: Dr. Weitzel & Partner
(86) International application number: PCT/JP2003/006766
(87) International publication number: WO 2003/100840

(57) **Abstract**

There is provided a vaporizer which can be used for a long period of time without being clogged and can supply a raw material stably to a reaction section. An object of the present invention is to provide a vaporizer which can supply a raw material adjusted to a stoichiometric ratio continuously and stably and has an effect of decreasing the quantity of residual carbon in a formed film, a disperser, a film forming apparatus, and a vaporizing method, and a dispersing method and a film forming method. The vaporizer for vaporizing a raw material solution contained in a carrier gas is **characterized in that** means for containing a solvent for the raw material solution in the carrier gas before containing the raw material solution is provided.

## Description

### TECHNICAL FIELD

The present invention relates to a vaporizer suitably used for a film forming apparatus such as a MOCVD film forming apparatus and a vaporizing method, and a film forming apparatus and other various types of apparatuses.

### BACKGROUND ART

A problem arising in the development of DRAM is a decrease in storage capacitance caused by miniaturization. From the viewpoint of software error, capacitance of the same level as that of the old generation is required, so that it is necessary to take some measures. As the measures, although the cell structure up to 1M has been a planar structure, from 4M, a three-dimensional structure called a stack structure or a trench structure has been adopted to increase the capacitor area. Also, for the dielectric film, which has conventionally been a thermally-oxidized film of substrate Si, a film formed by laminating a thermally-oxidized film and a CVD nitrided film on poly Si (this laminated film is generally called an ON film) has been adopted. For 16M DRAM, in order to further increase the area contributing to the capacitance, for the stack type, a three-dimensional type using the side surface, a fin type in which the back surface of plate is also used, and the like type have been used.

In such a three-dimensional structure, however, there arises a problem in that the number of processes increases due to the complication of process and the yield decreases due to the increase in height difference. For this reason, it is said that it is difficult to realize 256M bits or higher capacitance. Therefore, as one means for further increasing the degree of integration without changing the present structure of DRAM, there has been devised a method in which the dielectric of capacitance is changed over to one having a large dielectric constant. As a dielectric thin film having a large dielectric constant, attention was first paid to a thin film of a large dielectric constant single metal paraelectric oxide such as Ta₂O₅, Y₂O₃, and HfO₂. The specific dielectric constant of Ta₂O₅ is 28, that of Y₂O₃ is 16, that of HfO₂ is about 24, which are four to seven times that of SiO₂.

However, in application to DRAM of 256M or higher, a three-dimensional capacitor structure is needed. As a material which has a far larger specific dielectric constant than that of these oxides and is expected to be applied to DRAM, three kinds of (BaₓSr₁₋ₓ)TiO₃, Pb(Zr_{y}Ti_{1-y})O₃, and (PbₐL₁₋ₐ) (Zr_{b}Ti_{1-b})O₃ have been regarded as very likely materials.

Also, a Bi-based laminar structure having a crystalline structure highly similar to that of a superconductive material has recently received great attention because it has a large dielectric constant and self polarization of ferroelectric characteristic, and hence it is superior as a nonvolatile memory.

Generally, SrBi₂TaO₉ ferroelectric thin film is formed by the MOCVD (metal organic chemical vapor deposition) method which is practical and promising.

Generally, SrBi₂TaO₉ ferroelectric thin film is formed by the MOCVD (metal organic chemical vapor deposition) method which is practical and promising.

The raw materials for the ferroelectric thin film are, for example, three kinds of organic metal complexes of Sr(DPM)₂, Bi(C₆H₅)₃, and Ta(OC₂H₅)₅. Each of these materials is used as a raw material solution by being dissolved in THF (tetrahydrofuran), hexane, or other solvents. Sr(Ta(OEt)6)₂ and BI(OtAm)₃ are also used as a raw material solution by being dissolved in hexane or other solvents. DPM is the abbreviation of dipivaloylmethane.

The material properties of these raw materials are given in Table 1.

### Properties of raw material for ferroelectric thin film

| | Boiling point (°C) /pressure (mmHg) | Melting point (°C) |
|---|---|---|
| Sr(DPM)₂ | 231/0.1 | 210 |
| Bi(C₆H₅)₃ | 130/0.1 | 80 |
| Ta(OC₂H₅)₅ | 118/0.1 | 22 |
| THF | 67 | -109 |
| Sr(Ta(OEt)₆)₂ | 176/0.1 | 130 |
| BI(OtAm)₃ | 87/0.1 | 90 |

An apparatus used for the MOCVD method includes a reaction section in which the SrBi₂TaO₉ thin film raw material undergoes gas phase reaction and surface reaction to form a film and a supply section in which the SrBi₂TaO₉ thin film raw material and an oxidizing agent are supplied to the reaction section.

The supply section is provided with a vaporizer for vaporizing the thin film raw material.

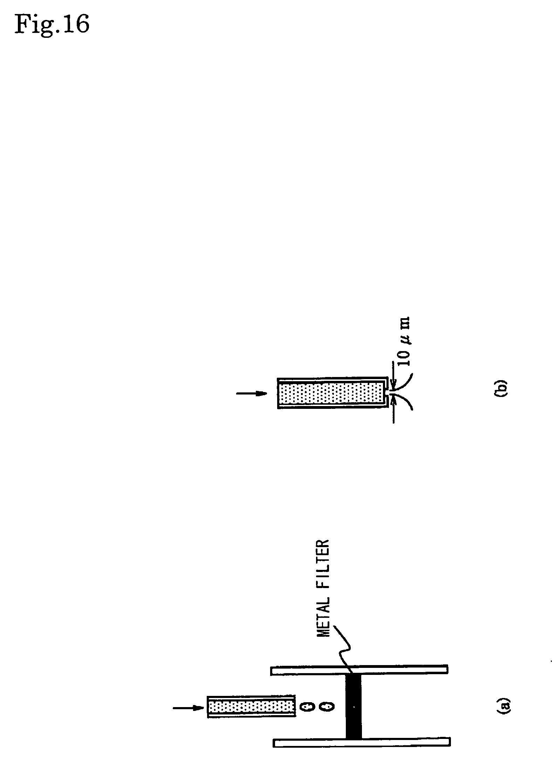

Conventionally, as a technique concerning the vaporizer, methods shown in Figure 16 has been known. The method shown in Figure 16(a), which is called a metal filter method, is a method in which vaporization is accomplished by introducing a raw material solution heated to a predetermined temperature to a metal filter used for increasing the contact area of gas existing in the surroundings with the SrBi₂TaO₉ ferroelectric thin film raw material solution.

However, in this technique, the metal filter is clogged by vaporization for several hours, which poses a problem in that this metal filter cannot be used for a long period of time. The inventor presumed that the reason for this is that the solution is heated and a substance having a lower vaporization temperature evaporates.

Figure 16(b) shows a technique in which a raw material solution is discharged through a minute hole of 10 µm by applying a pressure of 30 kgf/cm² to the raw material solution, by which the raw material solution is vaporized by expansion.

However, in this technique, the minute hole is clogged by vaporization for several hours, which poses a problem in that this minute hole cannot be used for a long period of time.

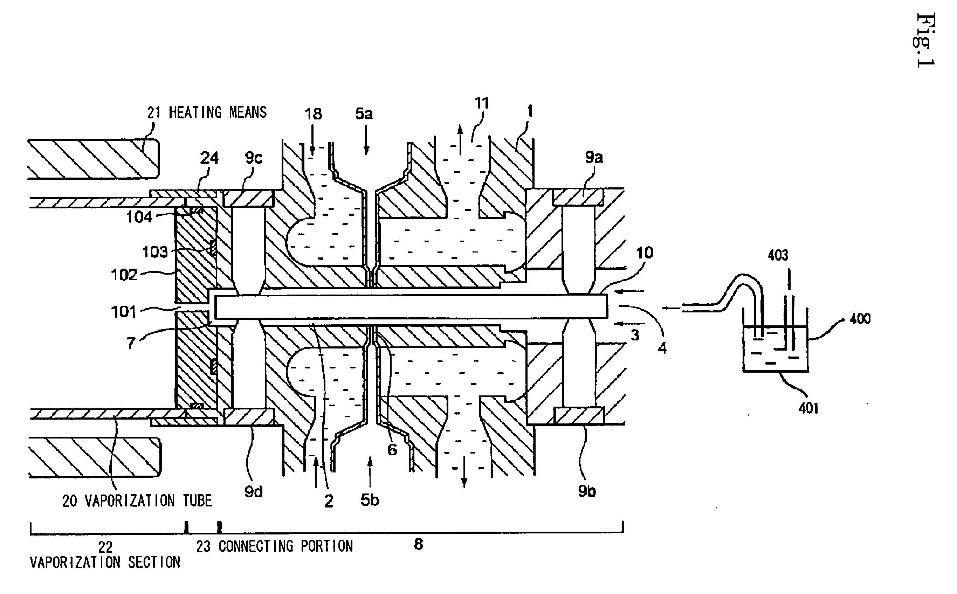

Also, in the case where the raw material solution is a mixed solution of a plurality of organic metal complexes, for example, a mixed solution of Sr(DPM)₂/THF and Bi(C₆H₅)₃/THF and (OC₂H₅)₅/THF, and vaporization is accomplished by the heating of this mixed solution, a solvent having the highest vapor pressure (in this case, THF) vaporizes earliest, which poses a problem in that the raw material cannot be supplied stably because the organic metal complexes deposit on the heated surface. In all methods shown in Figure 1, the quantity of heat capable of evaporating or changing the solvent is added in a liquid or mist state.

Furthermore, in the MOCVD, in order to obtain a film with high homogeneity, it is requested to obtain vaporized gas in which the raw material solution disperses homogeneously. However, the above-described conventional techniques do not necessarily meet the request.

To meet the above-described request, the inventor has separately provided a technique described below.

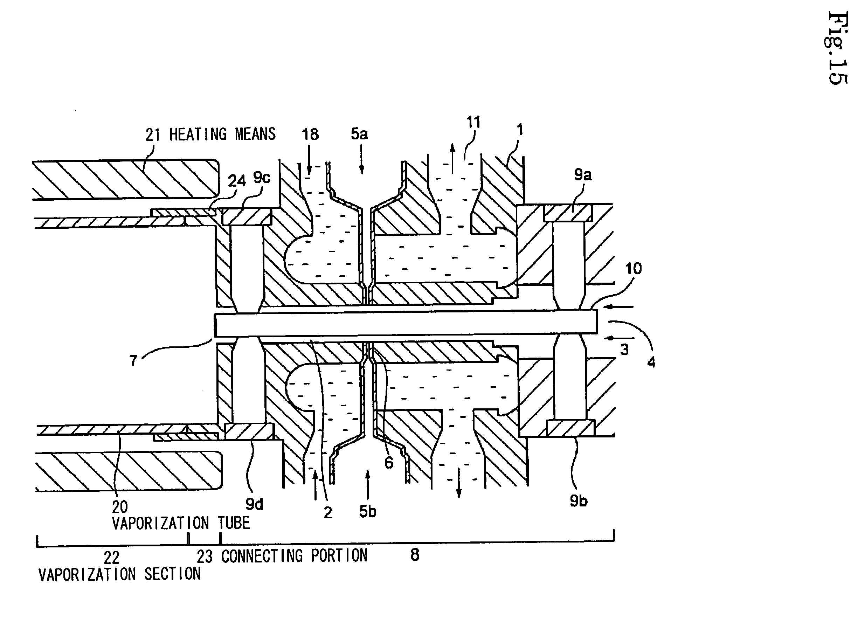

Specifically, as shown in Figure 15, there has been provided a vaporizer for MOCVD including:
(1) a dispersion section having a gas passage formed in the interior, a gas introduction port for introducing a pressurized carrier gas to the gas passage, means for supplying a raw material solution to the gas passage, a gas outlet for sending the carrier gas containing the raw material solution to a vaporization section, means for cooling the gas passage, and a radiation heat preventive blowoff portion cooled so that thermal energy is not applied to the raw material gas in the dispersion section by radiation heat from the vaporization section; and
(2) a vaporization section for heating and vaporizing the carrier gas containing the raw material solution sent from the dispersion section, having a vaporization tube one end of which is connected to a reaction tube of an MOCVD apparatus and the other end of which is connected to the gas outlet, and heating means for heating the vaporization tube, thermal energy being not applied to the raw material gas in the dispersion section by radiation heat from the vaporization section.

This technique provides a vaporizer for MOCVD that is clogged far less than the conventional example so that it can be used for a long period of time, and can supply a raw material stably to the reaction section.

Also, in this technique, an introduction port of oxygen heated beforehand is provided on the downstream side of the vaporization section.

However, in this technique as well, deposition of crystals is found in the gas passage, so that clogging still occurs in some cases.

Also, a large quantity of carbon (30 to 40 at%) is contained in the formed film. In order to remove this carbon, annealing (for example, 800°C, 60 minutes, oxygen atmosphere) must be performed at a high temperature after film formation.

Furthermore, in the case where film formation is accomplished, there occur large variations in percentage composition.

An object of the present invention is to provide a vaporizer which can be used for a long period of time without the occurrence of clogging etc, and can supply a raw material stably to the reaction section.

Another object of the present invention is to provide a vaporizer in which the content of carbon in a film can be made very low even in an as-deposited state and the percentage composition of film can be controlled exactly, a film forming apparatus and other various types of apparatuses, and a vaporizing method.

Still another object of the present invention is to provide a vaporizer and a vaporizing method in which a vaporized gas in which a raw material solution is dispersed homogeneously can be obtained.

Still another object of the present invention is to provide a vaporizer which can supply a raw material adjusted to a stoichiometric ratio continuously and stably and has an effect of decreasing the quantity of residual carbon in a formed film, a disperser, a film forming apparatus, and a vaporizing method, and a dispersing method and a film forming method.

### DISCLOSURE OF THE INVENTION

The present invention adds the following operation to enhance the performance of a vaporizer used for MOCVD etc. and to stabilize vaporization.

In order to vaporize organic metal compounds, at present, an inert gas or an inert gas containing a predetermined amount of oxygen is supplied to a narrow flow path of the vaporizer cooled to a temperature close to room temperature, a high-velocity air flow is produced, and a raw material is supplied to the air flow at a predetermined rate, by which the raw material is made in a mist form. Although the period of time for which the raw material comes into contact with the high-velocity air flow is short, the flow rate of the supplied inert gas or inert gas containing a predetermined amount of oxygen is higher than the quantity of supplied raw material, so that it is conjectured that a solvent for dissolving or dispersing the raw material is scattered in a gas phase by mass transfer. Therefore, the raw material for organic metal compound accumulates in a paste form in the flow path, which may be a cause for the instability in making the raw material in a mist form and the clogging of flow path.

To eliminate this cause, the air flow of inert gas or inert gas containing a predetermined amount of oxygen is beforehand made in a saturated state by the solvent used for the raw material, and then is supplied to the vaporizer. In this case, the object can be attained by bubbling the air flow of inert gas or inert gas containing a predetermined amount of oxygen in a container which contains the solvent and is kept at a predetermined temperature. Alternatively, the solvent of a quantity enough to saturate the air flow of solvent used for the raw material by means of the vapor of solvent has only to be supplied to a position just in front of the vaporizer of a raw material line supplied to the vaporizer. In this case as well, the quantity of supplied solvent is determined by the following simple formula by knowing the molecular weight and density of solvent, the pressure of air flow, the flow rate of air flow in a standard state, and the like under the data of the saturated vapor corresponding the temperature of vaporizer. V_{HC}^{25C,1am}(Liq.) - (M_{HC}/P_{HC}) {P_{HC}/(Pₜ-P_{M,C})} {1/ (RT₂₅) } (V_{00.25}+V_{02.25}) [mol/min]
where, M_{H,C} is the molecular weight of solvent (H,C) [g/mol], P_{H,C} is the density of solvent (H,C) [g/cm³], Pₜ is the total pressure of mixed gas in the vaporizer flow path [Torr], P_{H,C} is the saturated vapor pressure [Torr] gas constant (= 0.0824[1 atm/(K mol)]) of solvent (H,C) at temperature T[K] of vaporizer, T₂₅ is 25°C absolute temperature (= (273.15 25) [K]) , V_{00.25} is the flow rate of argon gas at 25°C, 1 cm [1/min], and V_{02.25} the flow rate of oxygen at 25°C, 1 atm [1/min]. However, Pₜ = P_{AR} + P_{O2} + P_{HC}. P_{AR} is the partial pressure of argon [Torr], P_{O2} is the partial pressure of oxygen [Torr], and P_{HC} is the partial pressure of solvent [Torr].

The vaporizer in accordance with the present invention is a vaporizer for vaporizing a raw material solution contained in a gas carrier, characterized in that means for containing a solvent for the raw material solution in the carrier gas before containing the raw material solution is provided.

The disperser in accordance with the present invention is a disperser for containing a raw material in a carrier gas, characterized in that means for containing a solvent of the raw material solution in the carrier gas before containing the raw material solution is provided.

The vaporizing method in accordance with the present invention is a vaporizing method for vaporizing a raw material solution contained in a carrier gas, characterized in that a solvent for the raw material solution is contained in the carrier gas before containing the raw material solution.

### BRIEF DESCRIPTION OF THE DRAWINGS

Figure 1 is a sectional view showing a principal portion of a vaporizer for MOCVD in accordance with example 1;
Figure 2 is a general sectional view of a vaporizer for MOCVD in accordance with example 1;
Figure 3 is a system diagram of MOCVD;
Figure 4 is a front view of a reserve tank;
Figure 5 is a sectional view showing a principal portion of a vaporizer for MOCVD in accordance with example 2;
Figure 6 is a sectional view showing a principal portion of a vaporizer for MOCVD in accordance with example 3;
Figures 7(a) and 7(b) are sectional views showing modifications of a gas passage of a vaporizer for MOCVD in accordance with example 4;
Figure 8 is a sectional view showing a vaporizer for MOCVD in accordance with example 5;
Figure 9 is a view of a rod used for the vaporizer for MOCVD in accordance with example 5, Figure 9(a) being a side view, Figure 9(b) being a sectional view taken along the line X-X, and Figure 9(c) being a sectional view taken along the line Y-Y;
Figure 10 is a side view showing a modification of Figure 9(a);
Figure 11 is a graph showing an experimental result in example 6;
Figure 12 is a side sectional view showing example 8;
Figure 13 is a schematic diagram showing a gas supply system of example 8;
Figure 14 is a side sectional view showing example 9;
Figure 15 is a sectional view showing the latest conventional technique;
Figures 16(a) and 16(b) are sectional views of a conventional vaporizer for MOCVD;
Figure 17 is a graph showing a crystallization characteristic of an SBT thin film;
Figure 18 is a graph showing a polarization characteristic of a crystallized SBT thin film;
Figure 19 is a detailed view of a vaporizer;
Figure 20 is a general view of a vaporizer;
Figure 21 is a view showing an example of an SBT thin film CVD apparatus using a vaporizer;
Figure 22 is a sectional view showing an example of a film forming apparatus;
Figure 23 is a view showing a construction for heating medium circulation used in Figure 22;
Figure 24 is a graph showing a film forming rate and a composition change as a function of the flow rate of reaction oxygen; and
Figure 25 is a graph showing a carbon content in a film as a function of the flow rate of reaction oxygen.

### [Explanation of reference numerals]

- 1: dispersion section body
- 2: gas passage
- 3: carrier gas
- 4: gas introduction port
- 5: raw material solution
- 6: raw material supply hole
- 7: gas outlet
- 8: dispersion section
- 9a, 9b, 9c, 9d: machine screw
- 10: rod
- 18: means for cooling (cooling water)
- 20: vaporization tube
- 21: heating means (heater)
- 22: vaporization section
- 23: connecting portion
- 24: joint
- 25: oxygen introducing means (primary oxygen (oxidizing gas) supply port)
- 29: raw material supply inlet
- 30a, 30b, 30c, 30d: mass-flow controller
- 31a, 31b, 31c, 31d: valve
- 32a, 32b, 32c, 32d: reserve tank
- 33,: carrier gas bomb
- 42: exhaust outlet
- 40: valve
- 44: reaction tube
- 46: gas pack
- 51: taper
- 70: groove
- 101: minute hole
- 102: radiation preventive portion
- 200: oxygen introducing means (secondary oxygen (oxidizing gas), carrier supply port)
- 301: upstream ring
- 302: downstream ring
- 303a, 303b: heat transfer path
- 304: heat conversion plate
- 304a: gas vent hole gas nozzle
- 306: exhaust outlet
- 308: orifice
- 312: substrate heater
- 320: heating medium inlet
- 321: heating medium outlet
- 390: heat input medium
- 391: heat output medium
- 3100: silicon substrate
- 400: container
- 401: solvent
- 402: solvent introduction passage
- 403: carrier gas

### BEST MODE FOR CARRYING OUT THE INVENTION

### [Example 1]

Figure 1 shows a vaporizer for MOCVD in accordance with example 1.

In this example, the vaporizer includes:
a dispersion section 8 having a gas passage 2 formed in a dispersion section body 1 forming the dispersion section,
a gas introduction port 4 for introducing a pressurized carrier gas 3 to the gas passage 2,
means (raw material supply hole) 6 for supplying a raw material solution 5 to the carrier gas passing through the gas passage 2 and for making the raw material solution 5 in a mist form,
a gas outlet 7 for sending the carrier gas (raw material gas) containing the mist-form raw material solution 5 to a vaporization section 22, and
means (cooling water) 18 for cooling the carrier gas flowing in the gas passage 2; and
the vaporization section 22 for heating and vaporizing the carrier gas in which the raw material solution is dispersed, which is sent from the dispersion section 8, having
a vaporization tube 20 one end of which is connected to a reaction tube of an MOCVD apparatus and the other end of which is connected to the gas outlet 7 of the dispersion section 8, and
heating means (heater) 21 for heating the vaporization tube 20, and
a radiation preventive portion 102 having a minute hole 101 is provided on the outside of the gas outlet 7.

Next, this example is explained in more detail.

In the example shown in Figure 1, the interior of the dispersion section body 1 is a cylindrical hollow portion. A rod 10 is inserted in the hollow portion, and the gas passage 2 is formed by the internal wall of the dispersion section body and the rod 10. The hollow portion is not limited to the cylindrical shape, and may take any other shapes. For example, a conical shape is preferable. The conical angle of the conical hollow portion is preferably 0 to 45°, more preferably 8 to 20°. The same is true in other examples.

The cross sectional area of the gas passage is preferably 0.10 to 0.5 mm². If it is less than 0.10 mm², the fabrication is difficult to do. If it exceeds 0.5 mm², it is necessary to use a high-pressure carrier gas with a high flow rate to speed up the carrier gas.

If the carrier gas with a high flow rate is used, a high-capacity large vacuum pump is needed to keep a reaction chamber in a depressurized state (for example, 1.0 Torr). Since it is difficult to use a vacuum pump having an evacuation capacity exceeding 10,000 liters/min (at 1.0 Torr), in order to achieve industrially practical application, a proper flow rate, i.e., a gas passage area of 0.10 to 0.5 mm² is preferable.

At one end of this gas passage 2, the gas introduction port 4 is provided. The gas introduction port 4 is connected with a carrier gas (for example, N₂, Ar, He) source (not shown).

At the side of a substantially central portion of the dispersion section body 1, the raw material supply port 6 is provided so as to communicate with the gas passage 2, so that the raw material solution 5 is introduced into the gas passage 2, and thus the raw material solution 5 can be dispersed in the carrier gas passing through the gas passage 2 to form the raw material gas.

At one end of the gas passage 2, the gas outlet 7 communicating with the vaporization tube 20 of the vaporization section 22 is provided.

In the dispersion section body 1, a space 11 for causing the cooling water 18 to flow is formed. By causing the cooling water 8 to flow in this space, the carrier gas flowing in the gas passage 2 is cooled. Alternatively, in place of this space, a Peltier element etc. may be provided to cool the carrier gas. Since the interior of the gas passage 2 of the dispersion section 8 is thermally affected by the heater 21 of the vaporization section 22, a solvent and an organic metal complex of the raw material solution do not vaporize at the same time in the gas passage 2, and only the solvent vaporizes. Therefore, by cooling the carrier gas in which the raw material solution is dispersed, flowing in the gas passage 2, vaporization of only the solvent is prevented. In particular, the cooling on the downstream side of the raw material supply hole 6 is important, and therefore at least a portion on the downstream side of the raw material supply hole 6 is cooled. The cooling temperature is a temperature equal to or lower than the boiling point of solvent. For example, in the case of THF, the cooling temperature is 67°C or lower. In particular, the temperature at the gas outlet 7 is important.

In this example, the radiation preventive portion 102 having the minute hole 101 is further provided on the outside of the gas outlet 7. Reference numerals 103 and 104 denote sealing members such as O-rings. This radiation preventive portion 102,for example, can be formed of Teflon (registered trade name), stainless steel, ceramics, or the like. Also, the radiation preventive portion 102 is preferably formed of a material having high thermal conductivity.

According to the knowledge of the inventor, in the conventional technique, the heat in the vaporization section overheats the gas in the gas passage 2 via the gas outlet 7 as radiation heat. Therefore, even if the gas is cooled by the cooling water 18, a low melting point component in the gas deposits near the gas outlet 7.

The radiation preventive portion is a member for preventing the radiation heat from propagating to the gas. Therefore, the cross-sectional area of the minute hole 101 is preferably smaller than the cross-sectional area of the gas passage 2. It is preferably equal to or less than 1/2, more preferably equal to or less than 1/3 of the cross-sectional area of the gas passage 2. Also, the minute hole is preferably miniaturized. In particular, it is preferably miniaturized to a size such that the flow velocity of emitting gas is subsonic.

Also, the length of the minute hole is preferably equal to or more than five times, more preferably equal to or more than ten times the minute hole size.

Also, by cooling the dispersion section, blockage due to carbide in the gas passage (especially the gas outlet) is prevented even if the vaporizer is used for a long period of time.

On the downstream side of the dispersion section body 1, the dispersion section body 1 is connected to the vaporization tube 20. The connection between the dispersion section body 1 and the vaporization tube 20 is made by a joint 24; and this portion serves as a connecting portion 23.

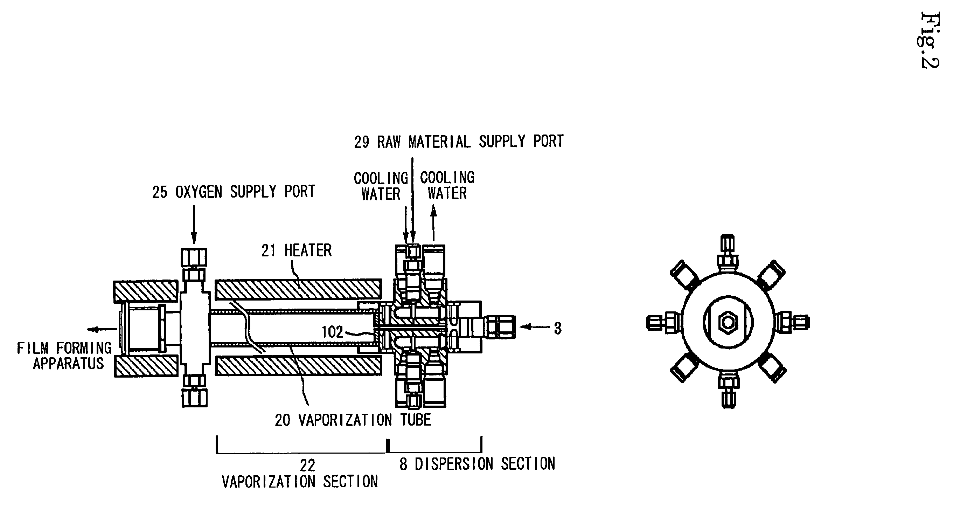

Figure 2 is a general view. The vaporization section 22 includes the vaporization tube 20 and the heating means (heater) 21. The heater 21 is a heater for heating and vaporizing the carrier gas in which the raw material solution is dispersed, flowing in the vaporization tube 20. The heater 21 has conventionally been formed by affixing a cylindrical heater or a mantle heater at the outer periphery of the vaporization tube 20. However, in order to heat the vaporization tube 20 so that a uniform temperature is achieved in the lengthwise direction of the vaporization tube, a method in which a liquid or a gas having high heat capacity is used as a heating medium is most excellent. Therefore, this method was used in this example.

As the vaporization tube 20, stainless steel, for example, SUS316L is preferably used. The dimensions of the vaporization tube 20 may be determined appropriately so that its length is enough to heat the vaporized gas. For example, when a SrBi₂Ta₂O₉ raw material solution of 0.04 ccm is vaporized, the vaporization tube 20 having an outside diameter of 3/4 inches and a length of several hundred millimeters can be used.

The downstream side end of the vaporization tube 20 is connected to a reaction tube of an MOCVD apparatus. In this example, an oxygen supply port 25 is provided on the vaporization tube 20 as oxygen supply means so that oxygen heated to a predetermined temperature can be fed to the carrier gas.

First, the supply of raw material solution to the vaporizer is described.

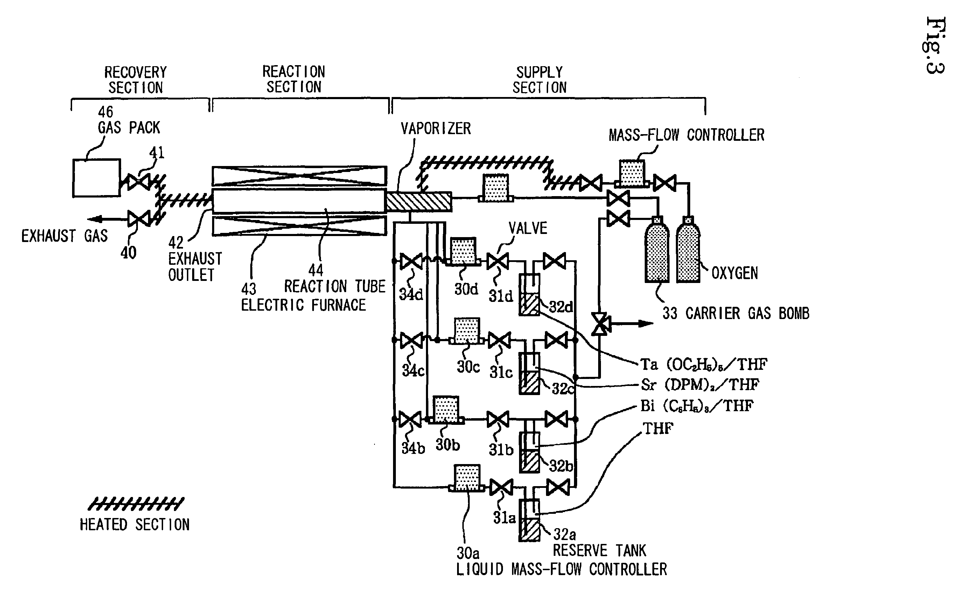

As shown in Figure 3, reserve tanks 32a, 32b, 32c and 32d are connected to the raw material supply port 6 via mass-flow controllers 30a, 30b, 30c and 30d and valves 31a, 31b, 31c and 31d, respectively.

Also, the reserve tanks 32a, 32b, 32c and 32d are connected with a carrier gas bomb 33.

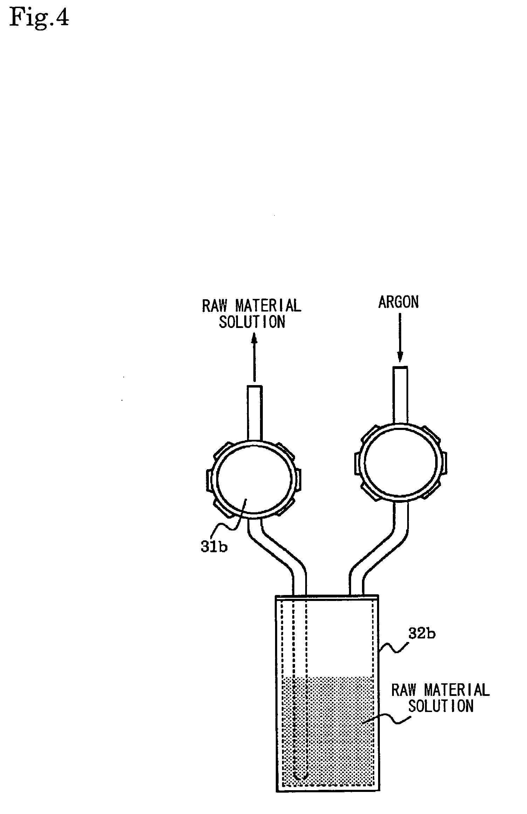

The details of the reserve tank are shown in Figure 4.

The reserve tank is filled with the raw material solution. The carrier gas (for example, inert gas Ar, He, Nc) of, for example, 1.0 to 3.0 kgf/cm² is sent into each of the reserve tanks (content volume: 300 cc, made of SUS). Since the interior of the reserve tank is pressurized by the carrier gas, the raw material solution is pushed up in the tube on the side contacting with the solution, and is sent under pressure to the liquid mass-flow controller (manufactured by STEC, full-scale flow rate: 0.2 cc/min), where the flow rate is controlled. The raw material solution is conveyed to the raw material supply hole 6 through a raw material supply inlet 29 of the vaporizer.

The raw material solution, whose flow rate has been controlled to a fixed value by the mass-flow controller, is conveyed to a reaction section by the carrier gas. At the same time, oxygen (oxidizing agent), whose flow rate has been controlled to a fixed value by a mass-flow controller (manufactured by STEC, full-scale flow rate: 2 L/min), is also conveyed to the reaction section.

Since in the raw material solution, a liquid-form or solid-form organic metal complex is dissolved in THF and other solvents at ordinary temperature, if it is left as it is, the organic metal complex is deposited by the evaporation of THF solvent, and it finally becomes in a solid form. Therefore, it is assumed that the tube in contact with the raw liquid may be blocked by the deposited organic metal complex. In order to restrain the blockage of tube, a cleaning line is provided considering that the interior of the tube and vaporizer should be cleaned with THF and other solvents after the film forming work has been finished. In the cleaning operation, a portion fitting to each work including raw material container replacement work in a section from the container outlet side to the vaporizer is washed off with the solvent.

The valves 31b, 31c and 31d were opened, and the carrier gas was sent under pressure into the reserve tanks 32b, 32c and 32d. The raw material solution is sent under pressure to the mass-flow controller (manufactured by STEC, full-scale flow rate: 0.2 cc/min), where the flow rate is controlled. The raw material solution is conveyed to the raw material supply hole 6 of the vaporizer.

On the other hand, the carrier gas was introduced through the gas introduction port of the vaporizer. The maximum pressure on the supply port side is preferably equal to or lower than 3 kgf/cm². At this time, the maximum flow rate of gas capable of passing through is about 1200 cc/min, and the flow velocity in the gas passage 2 reaches one hundred and several tens meters per second.

When the raw material solution is introduced through the raw material supply hole 6 to the carrier gas flowing in the gas passage 2 of the vaporizer, the raw material solution is sheared by the high-velocity flow of carrier gas and changed to ultrafine particles. As a result, the raw material solution is dispersed in the carrier gas in an untrafine particle state. The carrier gas in which the raw material solution is dispersed in an untrafine particle state (raw material gas) is atomized as being in a high-velocity state by the vaporization section 22 and is released. The angle formed between the gas passage and the raw material supply hole is optimized. In the case where the angle between a carrier flow path and a raw material solution introduction port is an acute angle (30 degrees), the solution is drawn by the gas. If the angle is equal to or larger than 90 degrees, the solution is pushed by the gas. The optimum angle is determined from the viscosity and flow rate of solution. When the viscosity or the flow rate is high, the solution is caused to flow smoothly by making the angle more acute. In the case where hexane is used as the solvent to form an SBT film, an angle of about 84 degrees is preferable because both viscosity and flow rate are low.

Three kinds of raw material solutions, whose flow rate has been controlled to a fixed value, flow into the gas passage 2 through the raw material supply hole 6 via the raw material supply inlet 29, and after moving in the gas passage together with the carrier gas, which forms a high-velocity gas flow, they are released to the vaporization section 22. In the dispersion section 8 as well, the raw material solution is heated by the heat from the vaporization section 22, and the evaporation of THF and other solvents is accelerated. Therefore, a section from the raw material supply inlet 29 to the raw material supply hole 6 and a section of the gas passage 2 are cooled by water or other cooling media.

The vaporization of the raw material solution, which is released from the dispersion section 8 and dispersed in the carrier gas in a fine particle form, is accelerated during the conveyance in the vaporization tube 20 heated to a predetermined temperature by the heater 21. By the feeding of oxygen heated to a predetermined temperature from the oxygen supply port 25 provided just before the raw material solution reaches the reaction tube of MOCVD, a mixed gas is formed, and flows into the reaction tube. In this example, evaluation was carried out by analyzing the reaction mode of vaporized gas in place of film formation.

A vacuum pump (not shown) was connected from an exhaust outlet 42 to remove water and other impurities in the reaction tube 44 by means of an evacuating operation for about 20 minutes, and a valve 40 on the downstream side of the exhaust outlet 42 was closed.

Cooling water was caused to flow in the vaporizer at a flow rate of about 400 cc/min. On the other hand, a carrier gas of 3 kgf/cm² was caused to flow at a flow rate of 495 cc/min. After the reaction tube 44 was sufficiently filled with the carrier gas, the valve 40 was opened. The temperature at the gas outlet 7 was lower than 67°C.

The interior of the vaporization tube 20 was heated to 200°C, a section from the reaction tube 44 to a gas pack 46 and the gas pack were heated to 100°C, and the interior of the reaction tube 44 was heated to 300°C to 600°C.

The interior of the reserve tank was pressurized by the carrier gas, and a predetermined liquid was caused to flow by the mass-flow controller.

Sr(DPM)₂, Bi(C₆H₅)₃, Ta(OC₂H₅)₅, and THF were caused to flow at flow rates of 0.04 cc/min, 0.08 cc/min, 0.08 cc/min, and 0.2 cc/min, respectively.

After 20 minutes, a valve just in front of the gas pack 46 was opened to recover a reaction product in the gas pack 46. The reaction product was analyzed with a gas chromatograph, and it was examined whether the detected product coincided with the product in the reaction formula studied based on the reaction theory. As a result, in this example, the detected product coincided well with the product in the reaction formula studied based on the reaction theory.

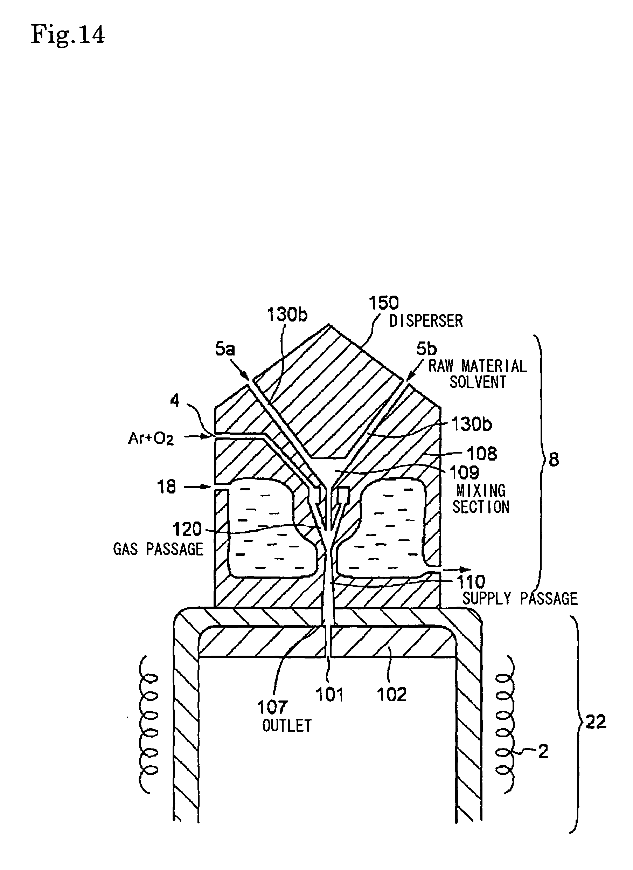

Also, the amount of carbides adhering to the external surface on the gas outlet 7 side of the dispersion section body 1 was measured. As the result, the amount of adhering carbides was very small, and was further smaller than in the case where the apparatus shown in Figure 14 was used.

In the case of a raw material solution in which a metal to be used as a film raw material is mixed with or dissolved in a solvent, the raw material solution is generally such that the metal becomes a complex and in a liquid/liquid state (perfect solvent solution). However, as the result of a careful examination of raw material solution conducted by the inventor, there was gained a knowledge that the metal complex is not necessarily in a scattered molecular state, and the metal complex itself is present as fine particles with a size of 1 to 100 nm in the solvent in some cases or is partially present as a solid/liquid state. It is considered that the clogging at the time of vaporization is liable to occur especially when the raw material solution is in such a state. When the evaporator in accordance with the present invention is used, clogging does not occur even when the raw material solution is in such a state.

Also, in a solution in which the raw material solution is present, the fine particles are liable to settle at the bottom by means of the gravity thereof. Therefore, to prevent clogging, it is preferable that convection be caused in the solution by heating the bottom portion (to a temperature equal to or lower than the evaporating temperature of solvent) to homogeneously disperse the fine particles. Also, it is preferable that not only the bottom portion be heated but also the side face of the container upper surface be cooled. Needless to say, the heating is performed at a temperature equal to or lower than the evaporating temperature of solvent.

It is preferable that a heater set or control the quantity of heat for heating the evaporation tube upper region so as to be larger than the quantity of heat for heating the downstream region. Specifically, since water-cooled gas blows off from the dispersion section, it is preferable that there be provided a heater that sets or controls the quantity of heat for heating so that the quantity of heat is large in the evaporation tube upper region and is small in the downstream region.

In addition to the above-described basic configuration, in this example, means for containing the solvent of raw material solution in the carrier gas before the raw material solution is contained in the carrier gas is provided.

The means for containing the solvent in the carrier gas is configured as described below in this example. A solvent 401 is stored beforehand in a container 400, and a carrier gas 403 is sent into the solvent to bubble the solvent. After the bubbling, the carrier gas is introduced to the gas introduction port 4.

An example in which an SBT ferroelectric thin film is formed by using the means for containing the solvent is described.

The raw materials of SBT are organic metal complexes dissolved in an organic solvent n-hexane C₆H₁₄ (boiling point at a pressure of 760 Torr is 68.7°C, melting point is - 95.8°C) of hexa-ethoxy-strontiumtantalum Sr(OC₂H₅)₂[Ta(OC₂H₅)₅]₂ (boiling point at a pressure of 0.1 Torr is 176°C, melting point is 130°C) and tri-t-amyloxybismuth Bi(0-t-C₅H₁₁)₃ (boiling point at a pressure of 0.1 Torr is 87°C(sublimation)).

The supply condition of raw material is 0.02 cc/min for organic metal complex of hexa-ethoxy-strontiumtantalum Sr(OC₂H₅)₂[Ta(OC₂H₅)₅]₂. On the other hand, the supply condition of raw material is also 0.02 cc/min for organic metal complex of tri-t-amyloxybismuth Bi(O-t-C₅H₁₁)₃. Also, the supply quantity of argon, which is an inert gas, is 200 (NTP)/min, and the supply quantity of oxygen is 10 (NTP)/min. To fill this mixed gas with vapor of n-hexane C₆H₁₄ at the temperature of vaporizer, 0.143/min of solvent n-hexane C₆H₁₄ was supplied to each line. By doing this, the air flow is saturated by the vapor of solvent.

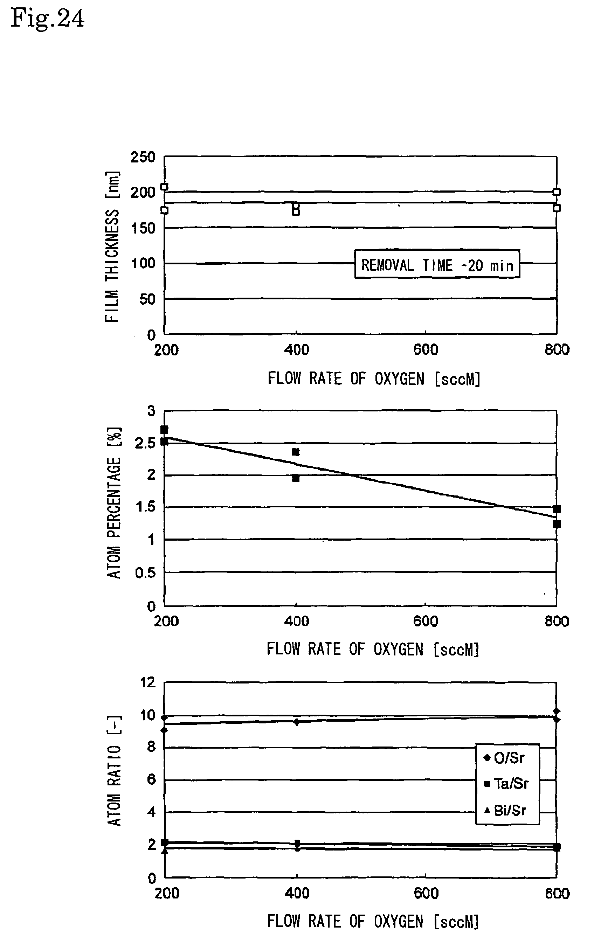

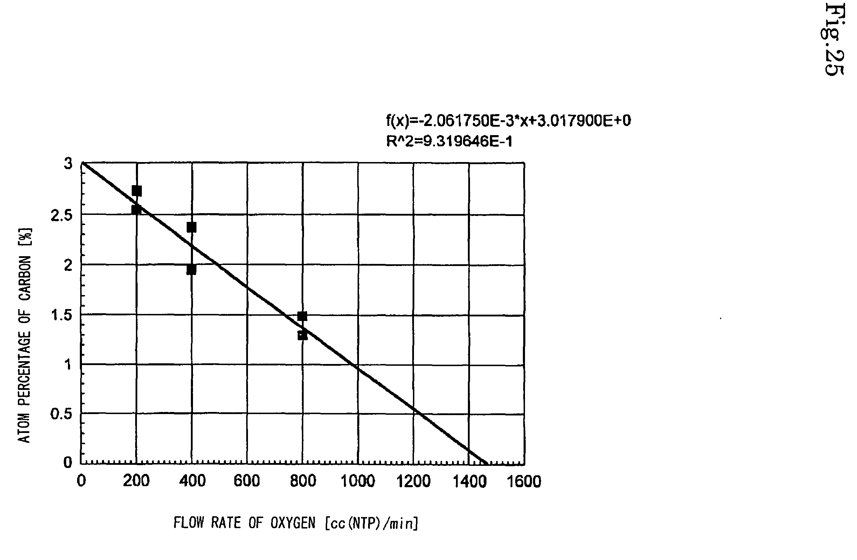

An experiment was conducted by setting the conditions as above-described. As a result, the occurrence of any trouble was not recognized in the vaporizer, and mist formation and vaporization were performed stably. Also, the accompanying figures 24 and 25 show the results of formation of SBT thin film carried out by changing the supply quantity of reaction oxygen under the above-described operation conditions.

As is apparent from the figures, it is understood that the film composition does not change even if the supply quantity of reaction oxygen is changed, and a composition of SrBi₂Ta₂O₂ can substantially be obtained. Also, it is found that even if the quantity of reaction oxygen is changed greatly, the thickness of SBT thin film is about 2000 X in 20 minutes. When the pressure of reactor is kept constant, and the flow rate of reaction oxygen is increased, the partial pressure of oxygen in the reactor increases, but the partial pressure of raw material decreases. This means that the number density of raw material molecules in the reactor decreases, and at the same time, the number of collisions of raw material molecules with the substrate decreases. Therefore, if the grow rate of film is regulated by the number of collisions of raw material molecules, the film formation rate should decrease along with the increase in flow rate of reaction oxygen. However, as is also apparent from the figures, the film formation rate is constant regardless of the flow rate of reaction oxygen. This suggests that the grow rate of film is not determined by the number of collisions of raw material molecules, but is determined by the reaction on the surface of substrate.

Also, it was shown that the operation for saturating the carrier gas (inert gas, or inert gas containing a predetermined oxygen) with solvent vapor has an effect that a raw material adjusted to a stoichiometric ratio can be supplied continuously and stably and the quantity of residual carbon in a formed film can be decreased.

Also, it was suggested that the carbon content in the film can be decreased by increasing the flow rate of reaction oxygen. It can be seen from the central graph of the accompanying figure (relationship between the flow rate of oxygen and the quantity of residual carbon) that in order to render the carbon content in the film zero, oxygen should be supplied at a flow rate of about 1430 [cc(NTP)/min].

By the setting of the above-described conditions, even in the case where different kinds of thin films are formed by using different raw materials adjusted to a stoichiometric ratio, if the solvent used for dissolving the raw material is supplied so that the carrier gas is likewise saturated by the vapor of solvent, the raw material is atomized continuously and stably by the evaporator, and is evaporated surely in a heating tube (pre-reactor), by which a thin film having an intended percentage composition can be obtained.

### [Example 2]

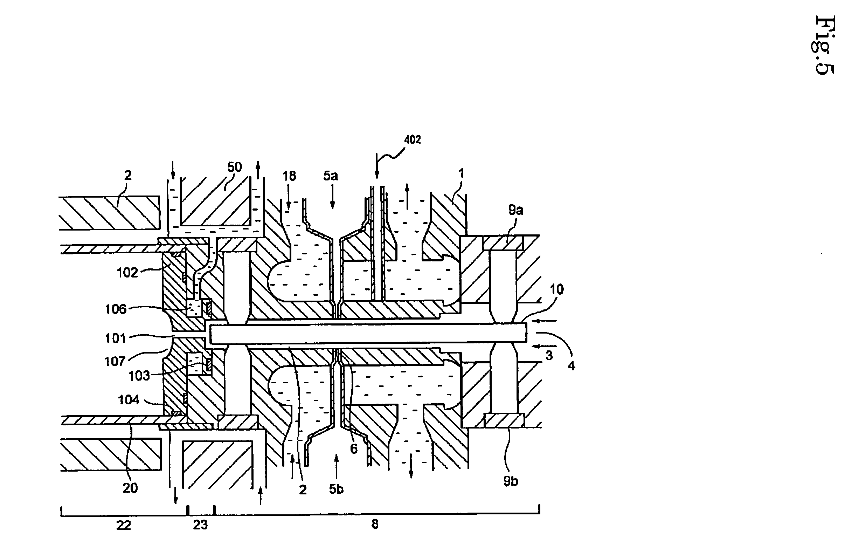

Figure 5 shows a vaporizer for MOCVD in accordance with example 2.

In this example, a cooling water passage 106 was formed at the outer periphery of the radiation preventive portion 102, and cooling means 50 was provided at the outer periphery of the connecting portion 23 to cool the radiation preventive portion 102.

Also, a concave portion 107 was provided around the outlet of the minute hole 101.

Other points are the same as in example 1.

In this example, the detected product coincided better with the product in the reaction formula studied based on the reaction theory than in the case of example 1.

Also, the amount of carbides adhering to the external surface on the gas outlet 7 side of the dispersion section body 1 was measured, with the result that the amount of adhering carbides was about 1/3 of the case of example 1.

Further, a solvent introduction passage 402 was provided. The solvent is introduced into the carrier gas 3 on the downstream side of the raw material supply hole 6 of the passage 2.

It is preferable that a flow meter be provided on the upstream side of the solvent introduction passage 402. Also, it is preferable that a sensor for measuring the temperature of vaporization section and a sensor for measuring the flow rate and pressure of carrier gas in the passage be provided. The signals from these sensors are processed, and the saturated vapor pressure of solvent is calculated. The solvent is preferably introduced so as to always achieve the saturated vapor pressure by controlling the quantity of introduced solvent by using the flow meter.

In this example, by introducing the solvent into the carrier gas, a film having a composition close to the stoichiometric ratio as compared with the case where the solvent was not introduced was obtained. Also, the carbon content was also low. Further, the frequency of occurrence of clogging decreased greatly.

In all of the following examples, the same improvement was found by introducing the solvent into the carrier gas.

### [Example 3]

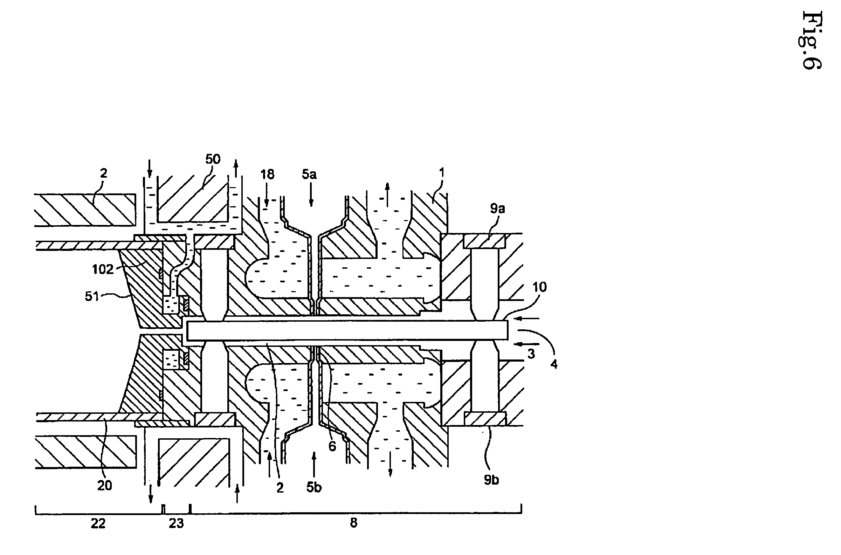

Figure 6 shows a vaporizer for MOCVD in accordance with example 3.

In this example, the radiation preventive portion 102 has a taper 51. This taper 51 eliminates a dead zone in this portion, so that the retention of raw material can be prevented.

Other points are the same as in example 2.

In this example, the detected product coincided better with the product in the reaction formula studied based on the reaction theory than in the case of example 2.

Also, the amount of carbides adhering to the external surface on the gas outlet side of the dispersion section body 1 was measured, with the result that the amount of adhering carbides was nearly zero.

### [Example 4]

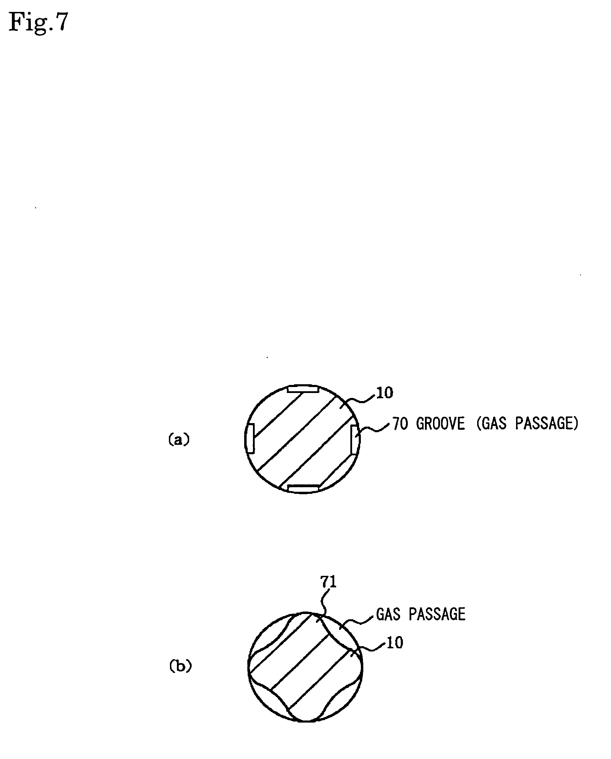

Figure 7 shows modified examples of the gas passage.

In Figure 7(a), grooves 70 are formed in the surface of the rod 10, and the outside diameter of the rod 10 is almost the same as the inside diameter of the hole formed in the dispersion section body 1. Therefore, merely by inserting the rod 10 in the hole, the rod can be arranged in the hole without eccentricity. Also, machine screws etc. need not be used. The grooves 70 serve as gas passages.

The grooves 70 may be formed in plural numbers in parallel with the axis in the lengthwise direction of the rod 10, or they may be formed in a spiral form in the surface of the rod 10. In the case of the spiral form, a raw material gas having high homogeneity can be obtained.

Figure 7(b) shows an example in which mixing portions are provided in the tip end portion of the rod 10. The largest diameter in the tip end portion is almost the same as the inside diameter of the hole formed in the dispersion section body 1. Spaces formed by the rod tip end portion and the internal surface of hole serve as gas passages.

The examples shown in Figures 7(a) and 7(b) are examples in which the surface of the rod 10 is machined. However, it is a matter of course that a rod having a circular cross section is used, and concave portions are formed in the surface of hole to provide gas passages. It is preferable that the rod be arranged in accordance with H7 x h6 - JS7 specified in JIS.

### [Example 5]

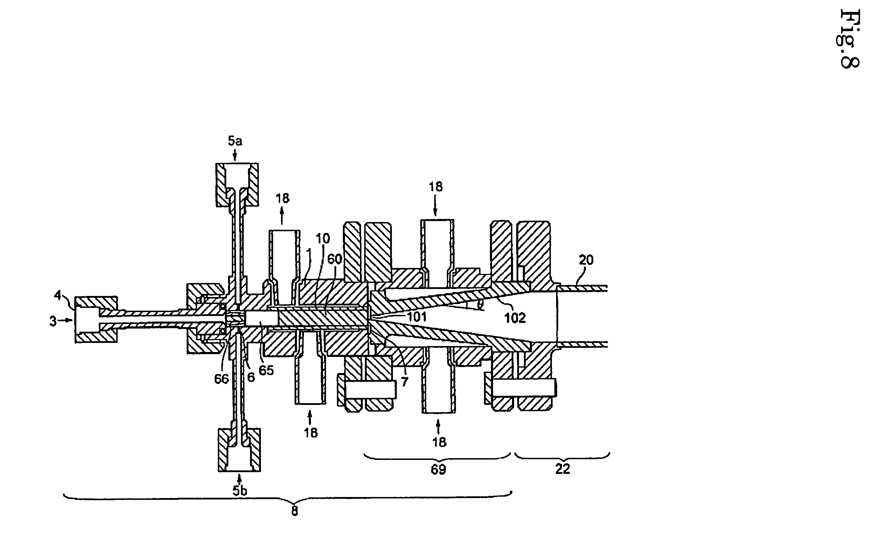

Example 5 is explained with reference to Figure 8.

The vaporizer for MOCVD of this example includes:
a dispersion section 8 having
a gas passage formed inside,
a gas introduction port 4 for introducing a pressurized carrier gas 3 into the gas passage,
means for supplying raw material solutions 5a and 5b to the gas passage, and
a gas outlet 7 for sending the carrier gas containing the raw material solutions 5a and 5b to a vaporization section 22; and
the vaporization section 22 for heating and vaporizing the carrier gas in which the raw material solutions are contained, which is sent from the dispersion section 8, having
a vaporization tube 20 one end of which is connected to a reaction tube of an MOCVD apparatus and the other end of which is connected to the gas outlet 7 of the dispersion section 8, and
heating means for heating the vaporization tube 20, and
the dispersion section 8 has a dispersion body 1 having a cylindrical hollow portion and a rod 10 having an outside diameter smaller than the inside diameter of the cylindrical hollow portion;
one or two or more spiral grooves 60 are formed on the vaporizer 22 side at the outer periphery of the rod 10;
the rod 10 is inserted in the cylindrical hollow portion; and
a radiation preventive portion 101 is provided which has a minute hole 101 on the outside of the gas outlet 7 and the inside diameter of which spreads in a taper shape toward the vaporizer 22.

When the raw material solution 5 is supplied to the gas passage through which the high-velocity carrier gas 3 flows, the raw material solution is sheared and atomized. Specifically, the raw material solution, which is a liquid, is sheared by a high-velocity flow of carrier gas, and made particles. The raw material solution having been made particles is dispersed in the carrier gas in a particulate state. This point is the same as in example 1.

In order to accomplish the shearing and atomization in the optimum manner, the following conditions are favorable.

The raw material solution 5 is supplied preferably at a rate of 0.005 to 2 cc/min, more preferably at a rate of 0.005 to 0.02 cc/min, and still more preferably at a rate of 0.1 to 0.3 cc/min. When a plurality of raw material solutions (including solvent) are supplied at the same time, the total quantity thereof should preferably be as described above.

Also, the carrier gas is supplied preferably at a rate of 10 to 200 m/sec, more preferably at a rate of 100 to 200 m/sec.

There is a mutual relation between the flow rate of raw material solution and the flow rate of carrier gas. It is a matter of course to select a cross-sectional area and a shape of flow path that realizes the optimum shearing and atomization and can obtain ultrafine particle mist.

In this example, the spiral groove 60 is formed at the outer periphery of the rod 10, and a gap space is present between the dispersion section body 1 and the rod 10. Therefore, the carrier gas containing the atomized raw material solution goes straight in this gap space as a straight flow, and also forms a swirl flow along the spiral groove 60.

The inventor found that the atomized raw material solution is dispersed uniformly in the carrier gas in the state in which the straight flow and the swirl flow coexist. The reason why uniform dispersion can be obtained if the straight flow and the swirl flow coexist is not necessarily clear. However, the following reason is possible. The existence of swirl flow produces a centrifugal force in the flow, and a secondary flow is produced. This secondary flow accelerates the mixing of the raw material with the carrier gas. That is, it is considered that a secondary derived flow is produced in the direction perpendicular to the flow by the centrifugal effect of swirl flow, and thereby the atomized raw material solution is dispersed uniformly in the carrier gas.

Next, this example is explained in more detail.

In this example, the configuration is such that as one example, four kinds of raw material solutions 5a, 5b, 5c and 5d (5a, 5b and 5c are organic metal raw materials and 5d is a solvent raw material such as THF) are supplied to the gas passage.

In order to mix the carrier gas containing the raw material solutions having been atomized and made in an ultrafine particle shape (referred to as a "raw material gas"), in this example, a portion in which the spiral groove is absent is provided on a downstream side of a portion corresponding to a raw material supply hole 6 of the rod 10. This portion serves as a premixing portion 65. In the premixing portion 65, the raw material gas of three kinds of organic metals is mixed to some extent, and further a perfectly mixed raw material gas is formed in the region of the downstream spiral structure. In order to obtain a uniformly mixed raw material gas, the length of the mixing portion 65 is preferably 5 to 20 mm, more preferably 8 to 15 mm. If the length thereof is out of the above range, only on kind of mixed raw material gas with a high concentration of the raw material gases of three kinds of organic metals is sometimes sent to the vaporization section 22.

In this example, an end portion 66 on the upstream side of the rod 10 is provided with a parallel portion 67 and a taper portion 58. In the cylindrical hollow portion of the dispersion section body 1 as well, a parallel portion having an inside diameter equal to the outside diameter of the parallel portion 67 of the rod 10, which corresponds to the parallel portion 67, and a taper portion with the same taper as the taper of the rod 10, which corresponds to the taper portion 58, are provided. Therefore, when the rod 10 is inserted from the left-hand side in the figure, the rod 10 is held in the hollow portion of the dispersion section body 1.

In this example, unlike the case of example 1, since the rod 10 is held with the taper being provided, even if a carrier gas having a pressure higher than 3 kgf/cm² is used, the rod 10 can be prevented from moving. Specifically, if the holding technique shown in Figure 8 is employed, the carrier gas can be caused to flow at a pressure equal to or higher than 3 kgf/cm². As a result, the cross-sectional area of gas passage is decreased, and a higher-velocity carrier gas can be supplied by a small quantity of gas. Specifically, a carrier gas with a high velocity of 50 to 300 mm/s can be supplied. The same is true if this holding technique is employed in the above-described other examples.

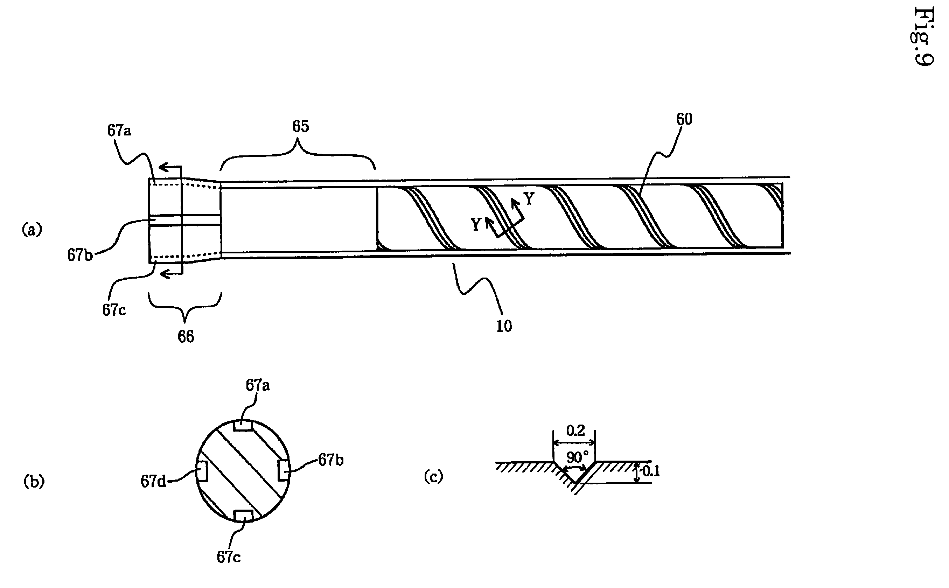

As shown in Figure 9(b), in a portion corresponding to the raw material supply hole 6 of the rod 10, grooves 67a, 67b, 67c and 67d are formed as carrier gas passages. The depth of each of the grooves 67a, 67b, 67c and 67d is preferably 0.005 to 0.1 mm. If the depth thereof is shallower than 0.005 mm, the machining of groove is difficult. Also, the depth thereof is more preferably 0.01 to 0.05 mm. The depth in this range prevents the occurrence of clogging etc. Also, it can easily provide a high-velocity flow.

For the holding of the rod 10 and the formation of gas passage, the construction shown in Figure 1 in example 1 or other constructions may be used.

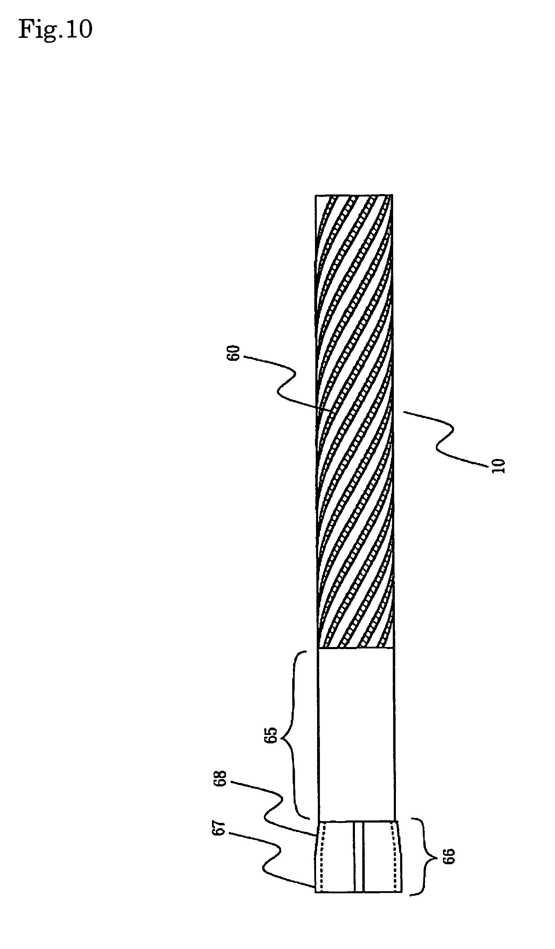

The number of the spiral grooves 60 may be one as shown in Figure 9(a), or may be any plural numbers as shown in Figure 10. Also, when the plurality of spiral grooves are formed, they may be crossed. When the spiral grooves 60 are crossed, a raw material gas dispersed more uniformly can be obtained. However, the cross-sectional area should be such that a gas flow velocity equal to or higher than 10 m/sec can be obtained in each groove.

The size and shape of the spiral groove 60 is not subject to any special restriction. The size and shape shown in Figure 9(c) is one example.

In this example, as shown in Figure 8, the gas passage is cooled by cooling water 18.

Also, in this example, an expansion section 69 is independently provided in front of the inlet of the dispersion section 22, and the lengthwise radiation preventive portion 102 is arranged in this expansion section 69.

The minute hole 101 is formed on the gas outlet 7 side of the radiation preventive portion, and the inside diameter of the minute hole 101 spreads in a taper shape toward the vaporizer side.

The expansion section 69 also serves to prevent the retention of raw material gas, which has been described in example 3. Needless to say, there is no need for independently provide the expansion section 69. The integrated construction as shown in Figure 6 may also be used.

The expansion angle θ of the expansion section 69 is preferably 5 to 10 degrees. When the expansion angle θ is within this range, the raw material gas can be supplied to the dispersion section without destroying the swirl flow. Also, when the expansion angle θ is within this range, the fluid resistance due to expansion becomes a minimum and also the presence of dead zone becomes a minimum, so that the presence of eddy current due to the presence of dead zone can be made a minimum. The expansion angle θ is more preferably 6 to 7 degrees. In the case of the example shown in Figure 6 as well, the preferable range of θ is the same.

### [Example 6]

The apparatus shown in Figure 8 was used, and the raw material solutions and the carrier gas were supplied under the following conditions, by which the homogeneity of raw material gas was investigated.

### Quantity of introduced raw material solutions:

| | |
|---|---|
| Sr(DPM)₂ | 0.04 cc/min |
| Bi(C₆H₅)₃ | 0.08 cc/min |
| Ta(OC₂H₅)₅ | 0.08 cc/min |
| THF | 0.2 cc/min |
| Carrier gas: nitrogen gas | 10 to 350 m/s |

As a vaporizing apparatus, the apparatus shown in Figure 8 was used. As a rod, the rod shown in Figure 9, which is not formed with the spiral groove, was used.

The raw material solutions were supplied from the raw material supply hole 6, and the carrier gas was supplied by changing the velocity thereof variously. From the raw material supply hole, Sr(DPM)₂ was supplied to the groove 67a, Bi(C₆H₅)₃ was supplied to the groove 67b, Ta(OC₂H₅)₅ was supplied to the groove 67c, and THF and other solvents were supplied to the groove 67d.

Heating was not performed in the vaporization section, and the raw material gas was sampled at the gas outlet 7 to measure the particle diameter of raw material solution in the sampled raw material gas.

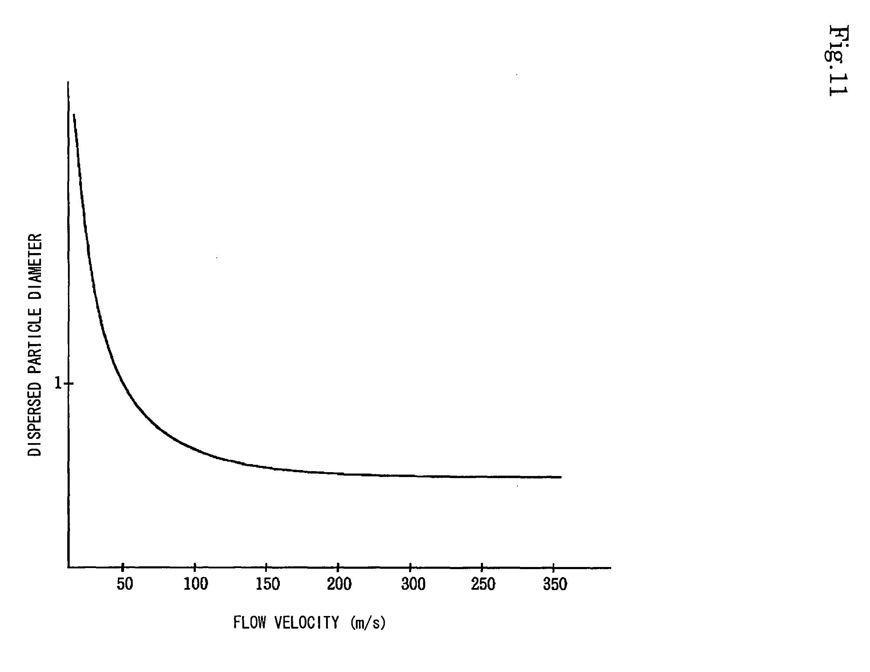

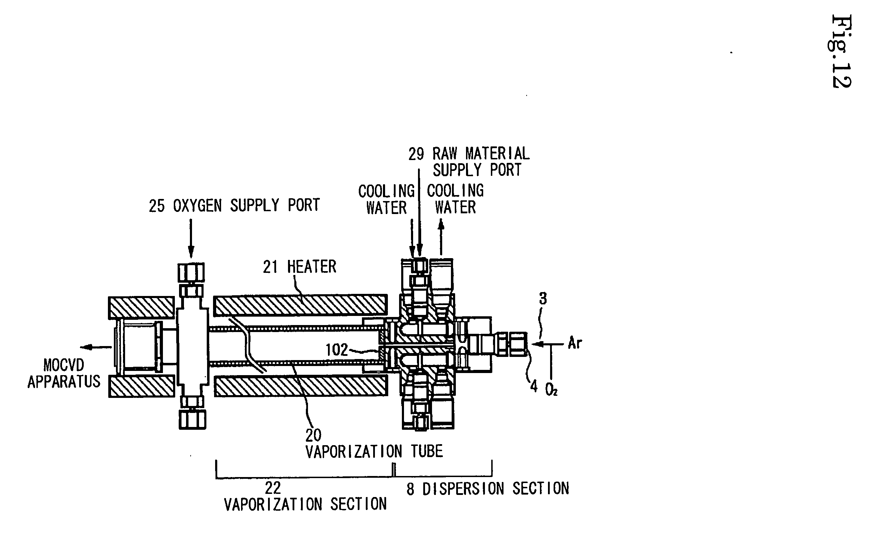

The measurement result is shown in Figure 11 as a relative value (the case where the apparatus of the conventional example shown in Figure 12(a) is taken as 1). As seen from Figure 11, by rendering the flow velocity equal to or higher than 50 m/s, the dispersed particle diameter decreases, and by rendering the flow velocity equal to or higher than 100 m/s, the dispersed particle diameter further decreases. However, when the flow velocity is rendered equal to or higher than 200 m/s, the dispersed particle diameter saturates. Therefore, the preferred range is 100 to 200 m/s.

### [Example 7]

In example 7, a rod formed with a spiral groove was used.

Other points are the same as in example 6.

In example 6, in an extended portion of the groove, the concentration of raw material solution supplied to the groove was high. Specifically, in an extended portion of the groove 67a, the concentration of Sr(DPM)₂ was high, in an extended portion of the groove 67b, the concentration of Bi(C₆H₅)₃ was high, and in an extended portion of the groove 67c, the concentration of Ta(OC₂H₅)₅ was high.

However, in this example, for the mixed raw material gas obtained at the end of spiral groove, each organic metal raw material was uniform in any portions.

### [Example 8]

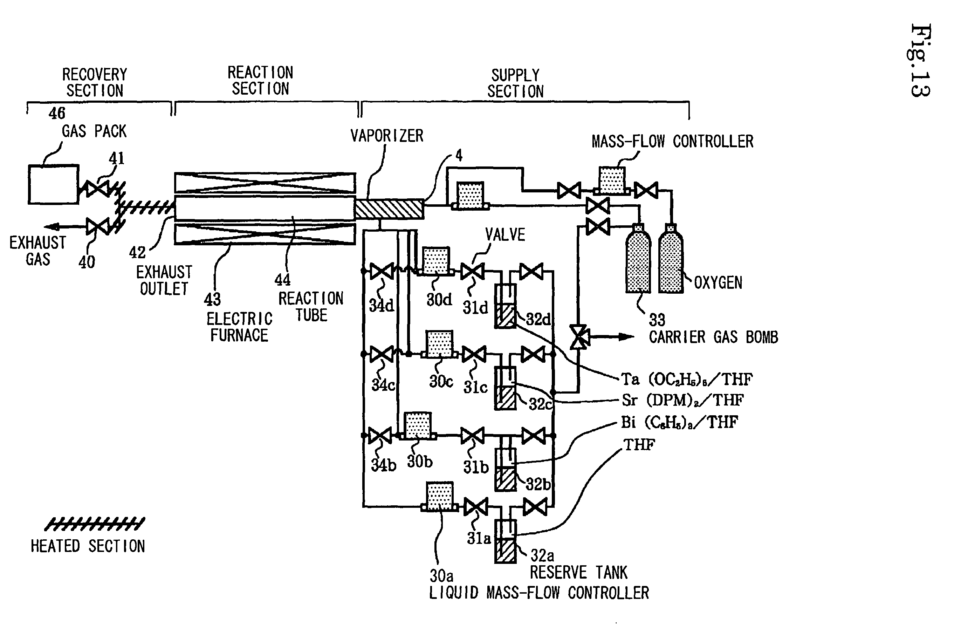

Example 8 is shown in Figures 12 and 13.

Conventionally, oxygen has been introduced only on the downstream side of the vaporization section 22 as shown in Figure 2. As described in the section of conventional technique, a large quantity of carbon is contained in the film formed by the conventional technique. Also, the composition in the raw material and the composition in the formed film have been different from each other. Specifically, when vaporization and film formation are accomplished by adjusting the raw material to the stoichiometric composition, the actually formed film has a composition different from the stoichiometric composition. In particular, a phenomenon such that bismuth is scarcely contained (about 0.1 at%) has been observed.

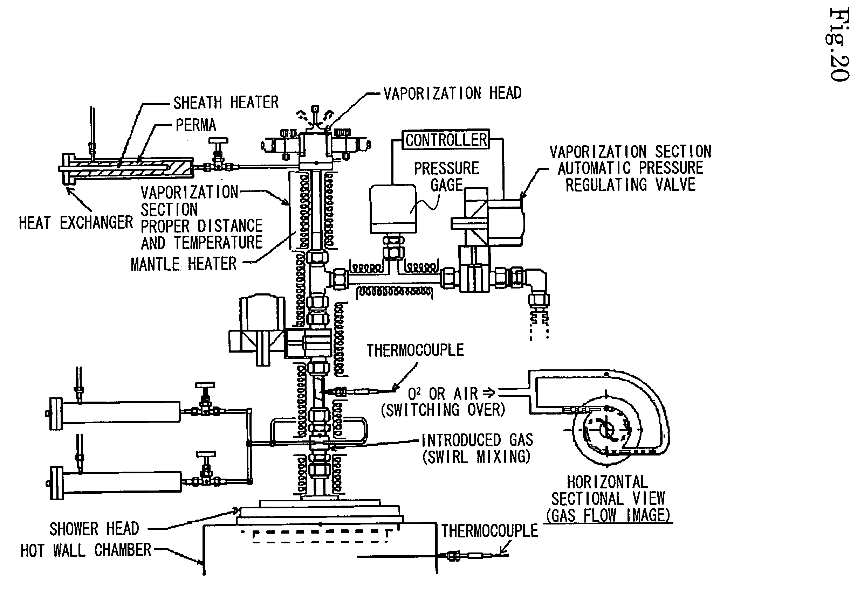

The inventor found that the cause for this relates to the introduction position of oxygen. Specifically, it was found that as shown in Figure 20, if oxygen is introduced, together with the carrier gas, from the gas introduction port 4, a secondary oxygen supply port 200 just near a blowoff port, and a oxygen introduction port (primary oxygen supply port) 25, the difference in percentage composition between the composition in the formed film and the composition in the raw material solution can be made extremely small.

It is optional to mix oxygen with the carrier gas in advance and to introduce this mixed gas through the gas introduction port 4.

### [Example 9]

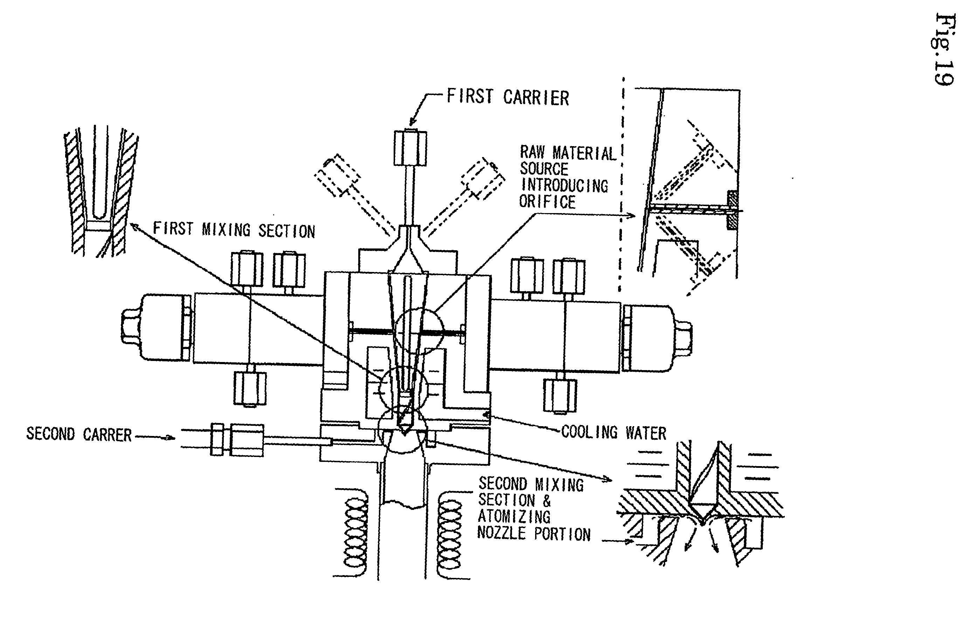

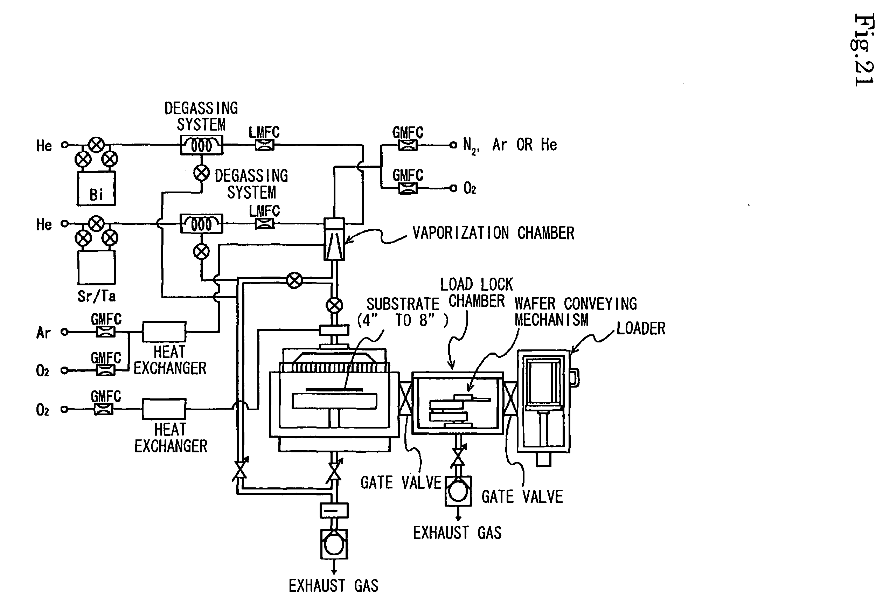

By using the vaporizer shown in Figures 19 and 20 and the CVD apparatus shown in Figure 21, an SBT film was formed, and further polarization characteristics etc. were evaluated.

Concretely, the conditions of vaporizer and reaction chamber were controlled as described below, and an SBT film was formed on a substrate obtained by forming platinum of 200 nm on an oxidized silicon substrate.

### Concrete conditions:

Hexaethoxystrontiumtantalum Sr[Ta(OC₂H₅)₆]₂ 0.1 mol solution (solvent: hexane) 0.02 ml/min
Tri-t-amyloxidbismuth Bi(O-t-C₅H₁₁)₃ 0.2 mol solution (solvent: hexane) 0.02 ml/min
First carrier Ar = 200 sccm (introduced through a gas introduction port 4)
First carrier O₂ = 10 sccm (introduced through a gas introduction port 4)
Second carrier Ar = 20 sccm (introduced through a gas introduction port 200)
O₂ = 10 sccm (introduced through a gas introduction port 200)
Reaction oxygen O₂ = 200 sccm (introduced from a dispersion blowoff portion lower portion 25)
Reaction oxygen temperature 216°C (temperature is
controlled by a heater provided separately before reaction oxygen is introduced from a dispersion blowoff portion lower portion)
Wafer temperature 475°C
Space temperature 299°C
Space distance 30 mm
Shower head temperature 201°C
Reaction pressure 1 Torr
Film forming time 20 minutes

### Results:

SBT film thickness about 300 nm (deposition speed about 150 nm/min)
SBT composition

| | |
|---|---|
| Sr | 5.4 at% |
| Bi | 16.4 at% |
| Ta | 13.1 at% |
| O | 61.4 at% |
| C | 3.5 at% |

The difference in percentage composition between the composition in the formed film and the composition in the raw material solution was very small, and the deposition speed was about five times the conventional speed. It is found that the effect of introducing small amount of oxygen through the gas introduction port 4 together with the carrier gas is extremely great. The carbon content is as low as 3.5 at%.

Because the temperature of the reaction oxygen (200 cc/min) was precisely controlled (to 216°C) by the separately provided heater before the reaction oxygen was introduced from the dispersion blowoff portion lower portion, from the fact that contamination of the lower part of evaporation tube was eliminated, it was verified that the effect of restraining the recondensation/sublimation(solidification) of vaporized organic metal compound is great.

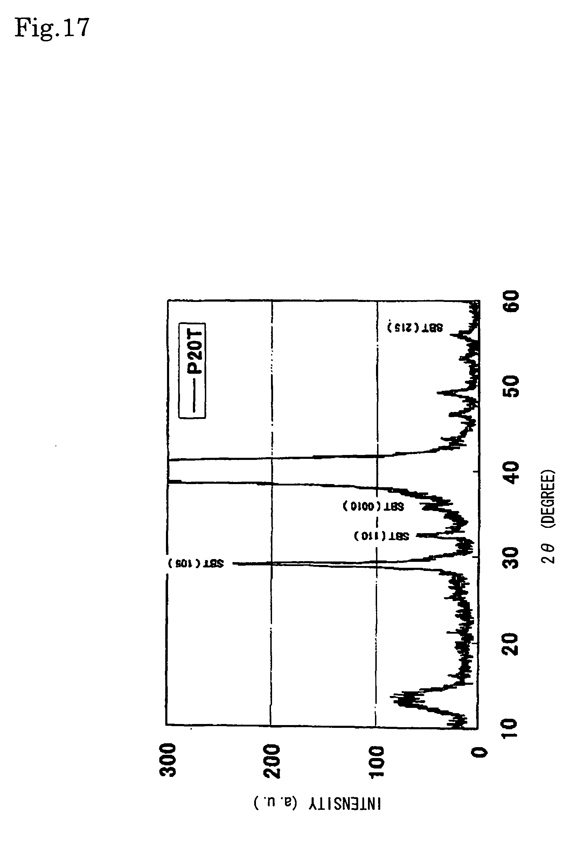

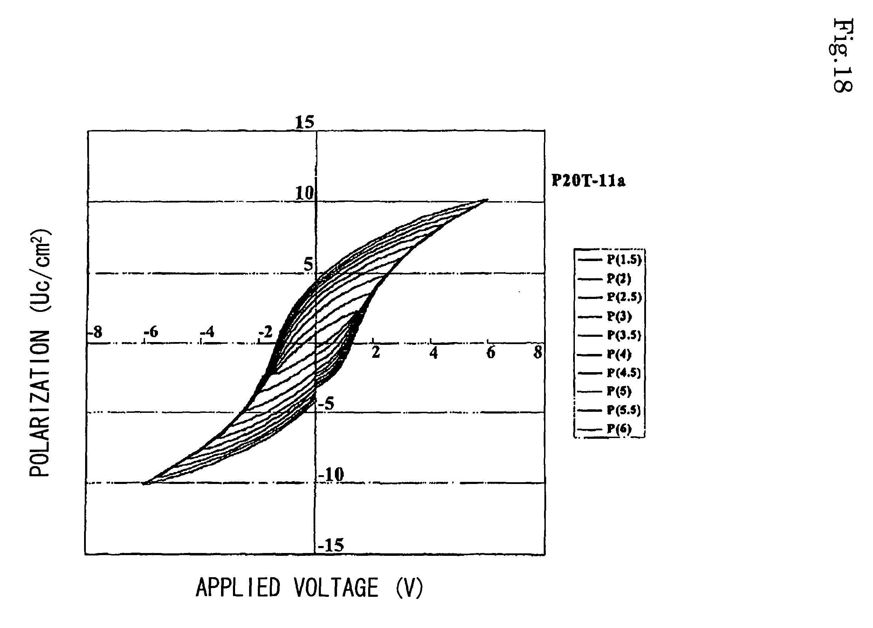

After the SBT thin film has been formed, crystallization treatment was performed at 750°C for 30 minutes in an oxygen atmosphere, and measurement and evaluation were carried out by forming an upper electrode. As a result, high crystallization characteristics and polarization characteristics were exhibited. These results are shown in Figures 17 and 18.

If an oxidizing gas such as oxygen is merely introduced through the gas introduction port 4 or a primary oxygen supply port just near a blowoff port, it is preferable that, as shown in figure 2, oxygen be introduced at the same time on the downstream side of a vaporization section and the quantity of oxygen be controlled appropriately, because by doing this, the difference in percentage composition is further decreased and the carbon content is also decreased.

The content of carbon in the formed film can be decreased to 5 to 20% of the conventional example.

An example of an SBT thin film deposition process is explained with reference to Figure 20.

A valve 2 is opened, and a valve 1 is closed, by which a reaction chamber is evacuated to a high vacuum. After several minutes, a wafer is transferred from a load lock chamber to a reaction chamber.

At this time, in a vaporizer,
hexaethoxystrontiumtantalum (Sr[Ta(OC₂H₅)₆]₂ 0.1 mol solution (solvent: hexane) 0.02 ml/min),
tri-t-amyloxidbismuth (Bi(O-t-C₅H₁₁)₃ 0.2 mol solution (solvent: hexane) 0.02 ml/min),
first carrier Ar = 200 sccm (introduced through a gas introduction port 4), and
first carrier O₂ = 10 sccm (introduced through a gas introduction port 4)
flow and are drawn to a vacuum pump through the valve 2 and an automatic pressure regulating valve.

At this time, the pressure gage is controlled to 4 Torr by the automatic pressure regulating valve.

When the temperature becomes stable several minutes after the wafer has been transferred, the valve 1 is opened, and the valve 2 is closed, by which the following gas is caused to flow into the reaction chamber to start deposition.
Hexaethoxystrontiumtantalum Sr[Ta(OC₂H₅)₆]₂ 0.1 mol solution (solvent: hexane) 0.02 ml/min
Tri-t-amyloxidbismuth Bi(O-t-C₅H₁₁)₃ 0.2 mol solution (solvent: hexane) 0.02 ml/min
First carrier Ar = 200 sccm (introduced through the gas introduction port 4)
First carrier O₂ = 10 sccm (introduced through the gas introduction port 4)
Second carrier Ar = 20 sccm (introduced through the gas introduction port 200)
O₂ = 10 sccm (introduced through the gas introduction port 200)
Reaction oxygen O₂ = 200 sccm (introduced from the dispersion blowoff portion lower portion 25)
Reaction oxygen temperature 216°C (temperature is controlled by the heater provided separately before reaction oxygen is introduced from the dispersion blowoff portion lower portion)
Wafer temperature 475°C

The reaction pressure chamber pressure is controlled to 1 Torr (by a not described automatic pressure regulating valve).

After predetermined time (20 minutes, in this example) has elapsed, the valve 2 is opened, and the valve 1 is closed, by which the deposition is finished.

The reaction chamber is evacuated to a high vacuum to remove the reaction gas completely, and after one minute, the wafer is taken out to the load lock chamber.

### Capacitor structure

Pt(200 nm)/CVDSBT(300 nm)/Pt(175 nm)/Ti(30 nm)/SiO₂/Si
Capacitor forming process
Lower electrode formation Pt(175 nm)/TI(30 nm) CVDSBT film formation (300 nm)
SBT film crystallization treatment (diffusion furnace annealing: wafer 750°C, 30 min, O₂ atmosphere)
Upper electrode formation Pt(200 nm)
Annealing: 650°C, O₂, 30 min

Conventionally, since the reaction oxygen (for example, 200 sccm) has been put in the vaporization tube in a room temperature state, the organic metal gas has been cooled, and adhered to and deposited in the vaporization tube.

When the temperature of the reaction oxygen supplied from the lower portion of evacuation section is controlled, conventionally, a heater has been wound around a stainless steel tube (outside dimension: 1/4 to 1/16 inch, length: 10 to 100 cm) to control the temperature of external wall of the stainless steel tube (to 219°C, for example).

It has been considered that the temperature of external wall of the stainless steel tube (219°C, for example) is equal to the temperature of oxygen (flow rate: 200 sccm) flowing inside.

However, the measurement of oxygen temperature with a minute thermocouple revealed that the temperature rise is only about 35°C in this example.

Therefore, the temperature of oxygen after being heated was measured directly with a minute thermocouple, and the heater temperature was controlled, by which the oxygen temperature was controlled accurately.

Since it was not easy to raise the temperature of gas such as oxygen flowing in the tube, the heat exchange efficiency was improved by putting a filler in the heating tube, and the temperature of heated oxygen gas was measured, by which the heater temperature was controlled properly. Means for such control is a heat exchanger shown in Figure 20.

### [Example 10]

Example 10 is shown in Figure 14.

In the above-described examples, gas is blown to each of the raw material solutions to atomize the single raw material solution, and subsequently, the atomized raw material solutions are mixed with each other. This example provides an apparatus in which a plurality of raw material solutions are mixed, and then the mixed raw material solutions are atomized.

The evaporator of this example includes:
a disperser 150 formed with a plurality of solution passages 130a and 130b for supplying raw material solutions 5a and 5b, a mixing section 109 for mixing the raw material solutions 5a and 5b supplied through the solution passages 130a and 130b, a supply passage 110 one end of which communicates with the mixing section 109 and which has an outlet 017 on the vaporization section 22 side, a gas passage 120 arranged so that a carrier gas or a mixed gas of the carrier gas and oxygen is blown to the mixed raw material solution coming from the mixing section 109 in the supply passage 110, and cooling means for cooling the interior of the supply passage 110; and
a vaporization section 22 for heating and vaporizing the gas containing the raw material solutions, which is sent from the disperser 150, having a vaporization tube one end of which is connected to a reaction tube of an MOCVD apparatus and the other end of which is connected to the outlet 107 of the disperser 150, and heating means 2 for heating the vaporization tube, and
a radiation heat preventive material 102 having a minute hole 101 is arranged on the outside of the outlet 107.

This example is effective for the raw material solutions the reaction of which does not proceed even if being mixed. Since the raw material solutions are atomized after being once mixed, the composition is exact as compared with the case where the raw material solutions are mixed after being atomized. Also, means (not shown) for analyzing the composition of mixed raw material solution in the mixing section 109 is provided, and the supply amounts of the raw material solutions 5a and 5b are controlled based on the analysis result, by which more exact composition can be obtained.

Also, in this example, a rod (reference numeral 10 in Figure 1) need not be used. Therefore, the heat propagating in the rod does not heat the interior of the supply passage 110. Further, the cross-sectional area of the supply passage 110 can be decreased as compared with the case where the raw material solutions are mixed after being atomized, and hence the cross-sectional area of the outlet 107 can be decreased, so that the interior of the supply passage 110 is scarcely heated by radiation. Therefore, the deposition of crystals can be decreased without providing the radiation preventive portion 102. In the case where it is desirable to further prevent the deposition of crystals, the radiation preventive portion 102 may be provided as shown in Figure 14.

Although the number of minute holes is one in the above-described examples, it is a matter of course that the number of minute holes may be plural. Also, the diameter of the minute hole is preferably equal to or smaller than 2 mm. When a plurality of minute holes are provided, the diameter can be made far smaller.

Also, in the above-described examples, in the case where the carrier flow path and the raw material solution introduction port make an acute angle (30 degrees), the solution is drawn by the gas. If the angle is equal to or larger than 90 degrees, the solution is pushed by the gas. Therefore, the angle is preferably 30 to 90°. Concretely, the optimum angle is determined from the viscosity and flow rate of solution. When the viscosity is high or the flow rate is high, the solution is caused to flow smoothly by making the angle more acute. Therefore, in implementation, the optimum angle corresponding to the viscosity and flow rate has only to be determined in advance by an experiment etc.

Also, in the above-described examples, it is optional to provide a mechanism for controlling the distance of space between a shower head and a susceptor to an arbitrary distance.

Furthermore, it is preferable that a liquid mass-flow controller for controlling the flow rate of raw material solution be provided, and degassing means for gas removal be provided on the upstream side of the liquid mass-flow controller. If degassing is not accomplished and the raw material solution is introduced to the mass-flow controller, variations in the formed films occur on the same wafer or between wafers. By introducing the raw material solution to the mass-flow controller after the removal of helium etc., the above-described variations in film thickness are decreased remarkably.

By providing means for controlling the temperature of raw material solution, helium transfer container, liquid mass-flow controller, and pipes in front of and behind the mass-flow controller to a fixed temperature, the variations in film thickness can further be prevented. Also, the change of properties of a chemically unstable raw material solution can be prevented. When the SBT thin film is formed, control is precisely carried out in the range of 5 to 20°C. The range of 12°C ± 1°C is especially preferable.

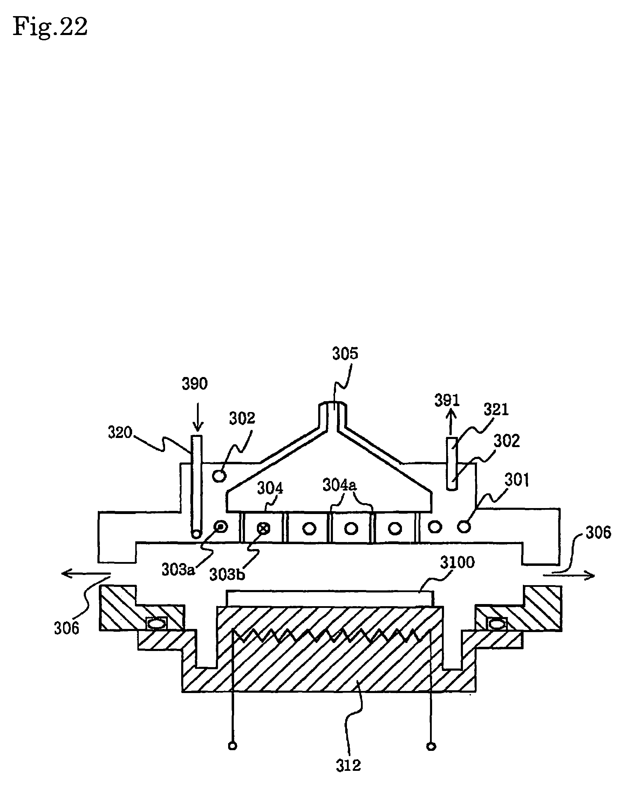

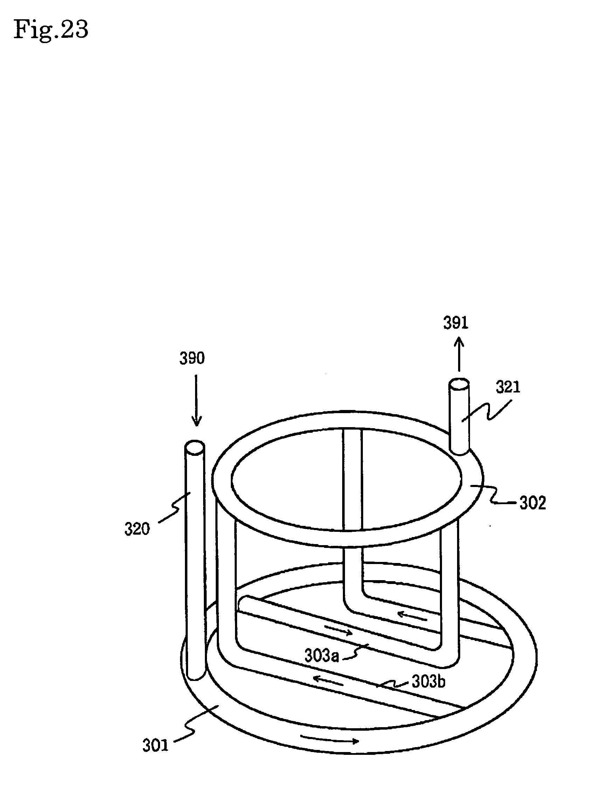

Also, in a substrate surface treatment apparatus in which a predetermined gas is blown to the substrate surface of a silicon substrate etc. to carry out surface treatment on the substrate surface as shown in Figures 22 and 23, it is optional to configure a heating medium circulation path having an upstream ring 301 connected to a heating medium inlet 320 for once-through flow of heating medium, a downstream ring 302 connected to a heating medium outlet 321 for a predetermined heating medium, and at least two heat transfer paths 303a and 303b which connect the upstream ring 1 and the downstream ring 2 to each other in the parallel direction, for making the gas at a predetermined temperature by alternating the flow path direction from the upstream ring 1 to the downstream ring 302 between the adjacent heat transfer paths 303a and 303b.

Also, the substrate surface treatment apparatus preferably has a heat conversion plate 304 thermally connected to the heating medium circulation path in a predetermined plane in the heating medium circulation path and in a plane formed in the flow path of the heating medium in the parallel direction so that the portion in the plane of the heat conversion plate 304 can be heated to a substantially uniform temperature by the heating medium.

Further, in the plane of the heat conversion plate 304, a plurality of vent holes for causing the predetermined gas to pass through in the vertical direction of the plane are preferably formed so that the predetermined gas passing through the vent hole can be heated to a substantially uniform temperature in the plane.

Thereupon, the configuration is such that the flow path direction from the upstream ring to the downstream ring between the adjacent heat transfer paths of the heating medium circulation path is alternated. Therefore, the difference in temperature in the regions adjacent to the heat transfer path is configured so as to be high/low/high/low .... By this configuration, the heat conversion plate can be heated or cooled uniformly. Further, a heat conversion plate thermally connected to the heating medium circulation path is provided in a plane formed in the flow path of heating medium in the parallel direction. Therefore, a portion in the plane of this heat conversion plate can be heated to a substantially uniform temperature by the heating medium.

The present invention can be applied to all vaporizers. The solvent contained in the carrier gas may be a gas or may be a liquid, also may be the same solvent as the solvent for the raw material solution or may be a different solvent from the solvent for the raw material solution.

### INDUSTRIAL APPLICABILITY

According to the present invention, there is provided a vaporizer used for a film forming apparatus such as a MOCVD film forming apparatus and other apparatuses, which can be used for a long period of time without being clogged, and can supply raw materials stably to a reaction section.

According to the present invention, a vaporized gas in which an organic metal material is dispersed uniformly can be obtained.

## Claims

1. A vaporizer for vaporizing a raw material solution contained in a gas carrier, **characterized in that** means for containing a solvent for said raw material solution in said carrier gas before containing said raw material solution is provided.

2. The vaporizer according to claim 1, **characterized in that** said solvent is contained so as to be in a saturated state at the temperature of said vaporizer.

3. The vaporizer according to claim 1 or 2, **characterized in that** a container containing said solvent is provided in front of a carrier gas introduction port of said vaporizer so that said carrier gas passes in said container.

4. The vaporizer according to claim 1 or 2, **characterized in that** a solvent introduction passage for introducing said solvent is provided on the downstream side of a portion in which said carrier gas is contained in said raw material solution.

5. The vaporizer according to claim 4, **characterized in that** a mass-flow controller is provided in said solvent introduction passage.

6. The vaporizer according to any one of claims 1 to 5, **characterized in that** said vaporizer comprises:
(1) a dispersion section having
a gas passage formed in the interior;
a gas introduction port for introducing said carrier gas to said gas passage;
means for supplying said raw material solution to said gas passage; and
a gas outlet for sending said carrier gas containing said raw material solution to a vaporization section, and
(2) the vaporization section for heating and vaporizing said carrier gas containing an atomized raw material solution, which is sent from said dispersion section, having
a vaporization tube one end of which is connected to a reaction section of a film forming apparatus or various types of apparatuses and the other end of which is connected to said gas outlet; and
heating means for heating said vaporization tube.

7. The vaporizer according to any one of claims 1 to 6, **characterized in that** means for cooling said gas passage is provided.

8. The vaporizer according to claim 6 or 7, **characterized in that** a radiation preventive portion having a minute hole is provided on the outside of said gas outlet.

9. The vaporizer according to any one of claims 6 to 8, **characterized in that** cooling means for cooling a portion connecting said dispersion section to said vaporization section is provided.

10. The vaporizer according to any one of claims 6 to 9, **characterized in that** said radiation preventive portion has a taper such that the inside diameter increases from the dispersion section side toward the vaporization section side.

11. The vaporizer according to any one of claims 6 to 11, **characterized in that** said dispersion section has a dispersion section body having a cylindrical or conical hollow portion and a rod having an outside diameter smaller than the inside diameter of said cylindrical or conical hollow portion, and
said rod is inserted in said cylindrical or conical hollow portion.

12. The vaporizer according to claim 11, **characterized in that** the angle of a cone of said conical hollow portion is 0 to 45 degrees.

13. The vaporizer according to claim 11 or 12, **characterized in that** the angle of a cone of said conical hollow portion is 8 to 20 degrees.

14. The vaporizer according to any one of claims 6 to 13, **characterized in that** said dispersion section has a dispersion section body having a cylindrical or conical hollow portion and a rod having an outside diameter approximately equal to the inside diameter of said cylindrical or conical hollow portion,
one or two or more grooves are formed at the outer periphery of said rod, and
said rod is inserted in said cylindrical or conical hollow portion.

15. The vaporizer according to claim 14, **characterized in that** said groove is a straight groove.

16. The vaporizer according to claim 14, **characterized in that** said groove is a spiral groove.

17. The vaporizer according to any one of claims 1 to 16, **characterized in that** said raw material solution is a homogeneous solution or a solution containing fine particles with a size of 1 to 100 nm.

18. The vaporizer according to any one of claims 1 to 17, **characterized in that** heating means is provided on the bottom surface of a container for said raw material solution.

19. The vaporizer according to any one of claims 1 to 5, **characterized in that** said vaporizer comprises:
(1) a dispersion section having
a gas passage formed in the interior;
a gas introduction port for introducing a pressurized carrier gas to said gas passage;
means for supplying said raw material solution to said gas passage; and
a gas outlet for sending said carrier gas containing said raw material solution to a vaporization section, and
(2) the vaporization section for heating and vaporizing said carrier gas containing said raw material solution, which is sent from said dispersion section, having
a vaporization tube one end of which is connected to a reaction section of a film forming apparatus or various types of apparatuses and the other end of which is connected to said gas outlet; and
heating means for heating said vaporization tube, and
(3) said dispersion section has a dispersion section body having a cylindrical or conical hollow portion and a rod having an outside diameter smaller than the inside diameter of said cylindrical or conical hollow portion, and
said rod has one or two or more spiral grooves on the vaporizer side at the outer periphery thereof, is inserted in said cylindrical or conical hollow portion, and has an inside diameter of which spreads in a taper shape toward said vaporizer.

20. The vaporizer according to claim 19, **characterized in that** a radiation preventive portion, which has a minute hole on the gas outlet side and the inside diameter of which spreads in a taper shape toward said vaporizer, is provided on the outside of said gas outlet.

21. The vaporizer according to claim 20, **characterized in that** said minute hole has a size such that the flow velocity of emitting gas is subsonic.

22. The vaporizer according to claim 20 or 21, **characterized in that** the cross-sectional area of said minute hole is smaller than the cross-sectional area of said gas passage.

23. The vaporizer according to any one of claims 20 to 22, **characterized in that** the cross-sectional area of said minute hole is equal to or less than 1/2 of the cross-sectional area of said gas passage.

24. The vaporizer according to any one of claims 20 to 23, **characterized in that** the cross-sectional area of said minute hole is equal to or less than 1/3 of the cross-sectional area of said gas passage.

25. The vaporizer according to any one of claims 20 to 24, **characterized in that** a material forming said minute hole is a material having high thermal conductivity.

26. The vaporizer according to any one of claims 20 to 25, **characterized in that** the length of said minute hole is equal to or more than five times the minute hole size.

27. The vaporizer according to any one of claims 20 to 26, **characterized in that** the length of said minute hole is equal to or more than ten times the minute hole size.

28. The vaporizer according to any one of claims 20 to 27, **characterized in that** means for cooling said gas passage is provided.

29. The vaporizer according to any one of claims 20 to 28, **characterized in that** cooling means for cooling a connecting portion connecting said dispersion section to said vaporization section is provided.

30. The vaporizer according to any one of claims 20 to 29, **characterized in that** the surface of said rod is a surface subjected to electrolytic polishing or composite electrolytic polishing.

31. The vaporizer according to any one of claims 20 to 30, **characterized in that** means for cooling said gas passage is provided.

32. The vaporizer according to any one of claims 20 to 31, **characterized in that** cooling means for cooling a portion connecting said dispersion section to said vaporization section is provided.

33. The vaporizer according to any one of claims 20 to 32, **characterized in that** said raw material solution is a perfect solvent solution or a solution containing fine particles with a size of 1 to 100 nm.

34. The vaporizer according to any one of claims 20 to 33, **characterized in that** heating means is provided on the bottom surface of a container for said raw material solution.

35. The vaporizer according to any one of claims 1 to 5, **characterized in that** said vaporizer comprises:
(1) a dispersion section having
a gas passage formed in the interior;
a gas introduction port for introducing a carrier to said gas passage;
means for supplying said raw material solution to said gas passage;
a gas outlet for sending said carrier gas containing said raw material solution to a vaporization section, and
means for cooling said gas passage, and
(2) the vaporization section for heating and vaporizing said carrier gas containing said raw material solution, which is sent from said dispersion section, having
a vaporization tube one end of which is connected to a reaction section of a film forming apparatus or various types of apparatuses and the other end of which is connected to said gas outlet; and
heating means for heating said vaporization tube, and
an oxidizing gas can be added to said carrier gas from said gas introduction port or an oxidizing gas can be introduced from a primary oxygen supply port.

36. The vaporizer according to claim 35, **characterized in that** a second carrier gas and/or the oxidizing gas can be introduced to a position just near said dispersion section.

37. The vaporizer according to claim 35 or 36, **characterized in that** cooling means for cooling a portion connecting said dispersion section to said vaporization section is provided.

38. The vaporizer according to any one of claims 35 to 37, **characterized in that** the portion connecting said dispersion section to said vaporization section has a taper such that the inside diameter increases from the dispersion section side toward the vaporization section side.

39. The vaporizer according to any one of claims 35 to 38, **characterized in that** said dispersion section has a dispersion section body having a cylindrical or conical hollow portion and a rod having an outside diameter smaller than the inside diameter of said cylindrical or conical hollow portion, and
said rod is inserted in said cylindrical or conical hollow portion.

40. The vaporizer according to any one of claims 35 to 39, **characterized in that** said dispersion section has a dispersion section body having a cylindrical or conical hollow portion and a rod having an outside diameter approximately equal to the inside diameter of said cylindrical or conical hollow portion,
one or two or more grooves are formed at the outer periphery of said rod, and
said rod is inserted in said cylindrical or conical hollow portion.

41. The vaporizer according to claim 40, **characterized in that** said groove is a straight groove.

42. The vaporizer according to claim 40, **characterized in that** said groove is a spiral groove.

43. The vaporizer according to any one of claims 40 to 42, **characterized in that** the flow velocity of gas etc. flowing in said groove is equal to or higher than 10 m/sec.

44. The vaporizer according to any one of claims 35 to 43, **characterized in that** the flow velocity of gas etc. flowing in said groove is equal to or higher than 15 m/sec.

45. The vaporizer according to any one of claims 35 to 44, **characterized in that** said raw material solution is a perfect solvent solution or a solution containing fine particles with a size of 1 to 100 nm.

46. The vaporizer according to any one of claims 35 to 44, **characterized in that** heating means is provided on the bottom surface of a container for said raw material solution.

47. The vaporizer according to any one of claims 35 to 46, **characterized in that** said oxidizing gas is any one or more kinds of O2, N2O, and NO2.

48. The vaporizer according to any one of claims 1 to 5, **characterized in that** said vaporizer comprises:
(1) a dispersion section having
a gas passage formed in the interior;
a gas introduction port for introducing a carrier to said gas passage;
means for supplying said raw material solution to said gas passage;
a gas outlet for sending said carrier gas containing said raw material solution to a vaporization section, and
means for cooling said gas passage, and
(2) the vaporization section for heating and vaporizing said carrier gas containing said raw material solution, which is sent from said dispersion section, having
a vaporization tube one end of which is connected to a reaction section of a film forming apparatus or various types of apparatuses and the other end of which is connected to said gas outlet; and
heating means for heating said vaporization tube, and
a radiation preventive portion having a minute hole is provided on the outside of said gas outlet so that
the carrier gas and an oxidizing gas can be introduced from said gas introduction port.

49. The vaporizer according to claim 48, **characterized in that** said carrier gas and/or oxidizing gas can be introduced to a position just near said dispersion section.

50. The vaporizer according to claim 48 or 49, **characterized in that** cooling means for cooling a portion connecting said dispersion section to said vaporization section is provided.

51. The vaporizer according to any one of claims 48 to 50, **characterized in that** said radiation preventive portion has a taper such that the inside diameter increases from the dispersion section side toward the vaporization section side.

52. The vaporizer according to any one of claims 48 to 51, **characterized in that** said dispersion section has a dispersion section body having a cylindrical or conical hollow portion and a rod having an outside diameter smaller than the inside diameter of said cylindrical or conical hollow portion, and
said rod is inserted in said cylindrical or conical hollow portion.

53. The vaporizer according to any one of claims 48 to 52, **characterized in that** said raw material solution is a perfect solvent solution or a solution containing fine particles with a size of 1 to 100 nm.

54. The vaporizer according to any one of claims 48 to 53, **characterized in that** heating means is provided on the bottom surface of a container for said raw material solution.

55. The vaporizer according to any one of claims 48 to 54, **characterized in that** said dispersion section has a dispersion section body having a cylindrical or conical hollow portion and a rod having an outside diameter approximately equal to the inside diameter of said cylindrical or conical hollow portion,
one or two or more grooves are formed at the outer periphery of said rod, and
said rod is inserted in said cylindrical or conical hollow portion.

56. The vaporizer according to claim 55, **characterized in that** said groove is a straight groove provided in said cylindrical or conical hollow portion.

57. A disperser for containing a raw material in a carrier gas, **characterized in that** means for containing a solvent of said raw material solution in said carrier gas before containing said raw material solution is provided.

58. The disperser according to claim 57, **characterized in that** said solvent is contained so as to be in a saturated state at the temperature of said vaporizer.

59. The disperser according to claim 57 or 58, **characterized in that** a container containing said solvent is provided in front of a carrier gas introduction port of said disperser so that said carrier gas passes in said container.

60. The disperser according to claim 57 or 58, **characterized in that** a solvent introduction passage for introducing said solvent is provided on the downstream side of a portion in which said carrier gas is contained in said raw material solution.

61. The disperser according to claim 60, **characterized in that** a mass-flow controller is provided in said solvent introduction passage.

62. The disperser according to any one of claims 57 to 61, **characterized in that** said disperser is formed with
a plurality of solution passages for supplying said raw material solution;
a mixing section for mixing a plurality of raw material solutions supplied through said solution passages;
a supply passage one end of which communicates with said mixing section and which has an outlet on the vaporization section side; and
a gas passage arranged so that the carrier gas or a mixed gas of the carrier gas and oxygen is blown to the mixed raw material solution coming from said mixing section in said supply passage.

63. The disperser according to claim 62, **characterized in that** cooling means for cooling said supply passage is provided.

64. The vaporizer according to any one of claims 1 to 5, **characterized in that** said vaporizer comprises:
a disperser formed with
a plurality of solution passages for supplying said raw material solution;
a mixing section for mixing a plurality of raw material solutions supplied through said solution passages;
a supply passage one end of which communicates with said mixing section and which has an outlet on the vaporization section side;
a gas passage arranged so that said carrier gas or a mixed gas of the carrier gas and oxygen is blown to the mixed raw material solution coming from said mixing section in said supply passage, and
cooling means for cooling said supply passage, and
a vaporization section for heating and vaporizing said carrier gas containing said raw material solution, which is sent from said dispersion section, having
a vaporization tube one end of which is connected to a reaction section of a film forming apparatus or various types of apparatuses and the other end of which is connected to a gas outlet of said disperser; and
heating means for heating said vaporization tube, and
a radiation preventive portion having a minute hole is provided on the outside of said outlet, and
a primary oxygen supply port capable of introducing an oxidizing gas is provided just near said dispersion emission portion.

65. The vaporizer according to claim 64, **characterized in that** a primary oxygen supply port capable of introducing a heated oxidizing gas whose temperature is controlled with high accuracy is provided at a lower part of said vaporization section.

66. The vaporizer according to claim 64 or 65, **characterized in that** the temperature of an oxidizing gas, which is heated and the temperature of which is controlled with high accuracy, can be controlled so as to be heating tube (vaporization tube) temperature ± 30°C.

67. The vaporizer according to claim 64 or 66, **characterized in that** the temperature of an oxidizing gas, which is heated and the temperature of which is controlled with high accuracy, can be controlled so as to be heating tube (vaporization tube) temperature ± 10°C.

68. The vaporizer according to any one of claims 64 to 67, **characterized in that** means for heating so that the tube wall temperature is uniform is provided.

69. The vaporizer according to any one of claims 64 to 68, **characterized in that** a heating heater is set or controlled so that the heating value of a region at an upper part of said vaporizer is higher than the heating value of a region on the downstream side.

70. The vaporizer according to any one of claims 64 to 68, **characterized in that** said vaporizer has a length necessary for raising the gas temperature in the vaporization tube to a point close to a set temperature.

71. The vaporizer according to any one of claims 64 to 70, **characterized in that** an angle formed between a carrier flow path and a raw material solution introduction port is 30 to 90 degrees.

72. A film forming apparatus **characterized by** having a vaporizer or a disperser according to any one of claims 1 to 70.

73. The film forming apparatus according to claim 72, **characterized in that** said film forming apparatus is a CVD apparatus.

74. The film forming apparatus according to claim 72 or 73, **characterized in that** said film forming apparatus is an MOCVD apparatus.

75. The film forming apparatus apparatus according to any one of claims 72 to 74, **characterized in that** said apparatus has a heated shower head for distributing a heated and gasified reaction gas uniformly in a large area.

76. The film forming apparatus according to claim 75, **characterized in that** means for uniformly heating said shower head to a fixed temperature by using a heated high-temperature gas (air, argon, etc.) is provided.

77. The film forming apparatus according to any one of claims 72 to 76, **characterized in that** said film is an SBT thin film.

78. The film forming apparatus according to any one of claims 74 to 77, **characterized in that** a mechanism for precisely controlling the temperature of a space between a shower head and a susceptor is provided.

79. The film forming apparatus according to any one of claims 74 to 78, **characterized in that** a mechanism for controlling the distance of a space between a shower head and a susceptor to an arbitrary distance.

80. The film forming apparatus according to any one of claims 72 to 79, **characterized in that** a liquid mass-flow controller for controlling the flow rate of a raw material solution is provided, and also degassing means for gas removal is provided on the upstream side of said liquid mass-flow controller.

81. The film forming apparatus according to claim 80, **characterized in that** means for controlling the temperature of the raw material solution, helium transfer container, liquid mass-flow controller, and pipes in front of and behind said mass-flow controller to a fixed temperature.

82. A vaporizing method for vaporizing a raw material solution contained in a carrier gas, **characterized in that** a solvent for said raw material solution is contained in said carrier gas before containing said raw material solution.

83. The vaporizing method according to claim 82, **characterized in that** said solvent is contained so as to be in a saturated state at the temperature of said vaporizer.

84. The vaporizing method according to claim 82 or 83, **characterized in that** a container containing said solvent is provided in front of a carrier gas introduction port of said vaporizer so that said carrier gas passes in said container.

85. The vaporizing method according to claim 82 or 83, **characterized in that** said solvent is introduced to the downstream side of a portion in which said carrier gas is contained in said raw material solution.

86. The vaporizing method according to claim 85, **characterized in that** a mass-flow controller is provided in said solvent introduction passage, and said solvent is introduced by controlling the pressure and flow rate of said solvent.

87. The vaporizing method according to any one of claims 82 to 86, **characterized in that** in a vaporizing method in which said raw material solution is introduced into a gas passage, and said carrier gas is injected toward the introduced raw material solution, by which said raw material solution is sheared and atomized into raw material mist, and next, said raw material mist is supplied to a vaporization section and is vaporized, oxygen is contained in said carrier gas.

88. The vaporizing method according to claim 86, **characterized in that** the injection velocity of said carrier gas is 10 to 200 m/s.

89. The vaporizing method according to claim 87 or 88, **characterized in that** said raw material solution is introduced at a rate of 0.005 to 2 cc/min.

90. The vaporizing method according to any one of claims 87 to 89, **characterized in that** on the downstream side of a portion in which said raw material solution is introduced, the carrier gas or a raw material gas is caused to flow as both a spiral flow and a straight flow flowing at an upper layer of said spiral flow.

91. The vaporizing method according to any one of claims 87 to 90, **characterized in that** a raw material gas is cooled between a portion in which said raw material solution is introduced and said vaporization section.

92. The vaporizing method according to any one of claims 88 to 91, **characterized in that** the wall of a vaporization tube is heated uniformly by using a heating medium consisting of a liquid or a gas having high heat capacity.

93. The vaporizing method according to any one of claims 87 to 92, **characterized in that** said raw material solution is sent under pressure by using helium having high gas solubility.

94. The vaporizing method according to any one of claims 87 to 93, **characterized in that** after a slightly dissolved gas is removed, the flow rate of raw material solution is controlled precisely by using a liquid mass-flow controller etc.

95. The vaporizing method according to any one of claims 87 to 94, **characterized in that** the temperature of the raw material solution, helium transfer container, liquid mass-flow controller, and pipes in front of and behind said mass-flow controller is controlled to a fixed temperature.

96. The vaporizing method according to claim 95, **characterized in that** said temperature is controlled in the range of 5 to 20°C when an SBT thin film is formed.

97. The vaporizing method according to claim 95 or 96, **characterized in that** said temperature is controlled in the range of 12°C ± 1°C when an SBT thin film is formed.

98. The vaporizing method according to any one of claims 87 to 97, **characterized in that** the temperature of the raw material solution, helium transfer container, liquid mass-flow controller, and pipes in front of and behind said mass-flow controller is controlled to a fixed temperature.

99. A film forming method **characterized in that** the vaporizing method described in any one of claims 82 to 98 is used.

100. The film forming method according to claim 99, **characterized in that** fluctuations in flow rate at the time when a reaction gas is caused to flow in a reaction chamber is restrained by causing an accumulated gas to flow continuously to the vent side through a vaporizer during the reaction waiting time.

101. The film forming method according to claim 98 or 99, **characterized in that** when an accumulated gas is caused to flow continuously to the vent side through a vaporizer during the reaction waiting time, the pressure of said vaporizer is controlled, by which fluctuations in pressure and flow rate at the time when a reaction gas is caused to flow in a reaction chamber is restrained.

102. The film forming method according to any one of claims 99 to 101, **characterized in that** a heated and gasified reaction gas is distributed uniformly in a large area by using a heated shower head.

103. The film forming method according to claim 102, **characterized in that** said shower head is heated uniformly to a fixed temperature by using a heated high-temperature gas (air, argon, etc.).

104. The film forming method according to any one of claims 99 to 103, **characterized in that** said film is an SBT thin film.

105. The film forming method according to any one of claims 102 to 104, **characterized in that** the temperature of said shower head is controlled to 180 to 250°C.

106. The film forming method according to any one of claims 102 to 105, **characterized in that** the temperature of said shower head is controlled to 200 to 220°C.
